# EUROPEAN PATENT APPLICATION

(11) **EP 0 634 839 A1**
(43) Date of publication of application: **18.01.1995**
(21) Application number: 94304954.4
(22) Date of filing: 05.07.1994
(51) Int. Cl.: H03M 7/30, G06F 17/30

(54) **Data search device**

(30) Priority: 16.07.1993 JP 176737/93; 20.12.1993 JP 319944/93
(71) Applicant: International Business Machines Corporation, Armonk, N.Y. 10504 (US)
(72) Inventor: Satoh, Akashi, Yamato-shi, Kanagawa-ken (JP); Niijima, Hideto, Toshima-ku, Tokyo (JP)
(74) Representative: Davies, Simon Robert

(57) **Abstract**

A character string to be searched (BABCABB..) is stored in order in an associative memory cell row of an associative memory 26. A first character (A) of a search character string is inputted to a buffer 56, and comparison operations are effected at all of the cell rows. Comparison operations with the next character (B) are effected only at the cell rows of addresses (2), (5) which are adjacent to the cell rows which matched the previous time. Similarly, comparison operations for the next character (C) are effected only at cell rows of addresses (3), (6) and so on. Thus even if the length of the search character string is a variable length, only the number of times the comparison operation is repeated varies.

## Description

The present invention relates to a data search device which searches for search data such as a character string or the like in data to be searched, for use for example in data compression, and in particular, data compression in which repeat data is searched for from among original data.

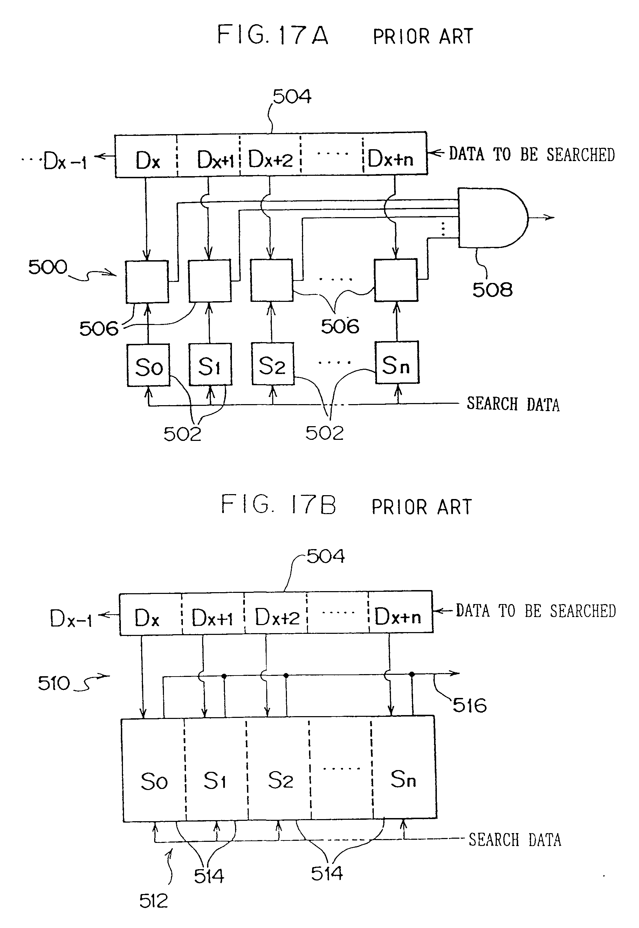

In fields such as computers, searches for predetermined search data such as a character string or the like are effected frequently (for example, during data compression, which will be described later). Such a search is often executed by software, but in order to shorten the processing time, it is effective to carry out searching by hardware. Various conventional structures for search circuits which search for search data from among data to be searched have been proposed. An example of a search circuit is illustrated in Fig. 17A.

A search circuit 500 illustrated in Fig. 17A is formed by a plurality of registers 502, a shift register 504, a plurality of comparators 506, and an AND circuit 508. Retrieval data S₀ through Sₙ are stored in the plurality of registers 502. The shift register 504 holds a portion of data to be searched D₀... . The comparators 506 compare the data held in the registers 502 and the data held in the shift register 504 and output a high-level comparing signal when the data match. The comparing signals outputted from the respective comparators 506 are inputted to the AND circuit 508. The data to be searched are successively inputted to the search circuit 500 by the data held in the shift register 504 being shifted. When search data is found in the data to be searched, the comparing signals outputted from all of the comparators 506 become high level, and the signal outputted from the AND circuit 508 becomes high level so that discovery of the search data is detected.

A conventional associative memory (content addressable memory: CAM) is known as an example of hardware used in searches and the like. In a general memory, when an address of a stored position is designated, data stored in the storage region corresponding to the address is output. However, in an associative memory, when data is designated, the address of the storage region in which the data is stored is outputted. In a data search device using a conventionally-proposed associative memory (e.g., Japanese Patent Application Laid-Open No. 2-66671), in a search circuit 510 illustrated conceptually in Fig. 17B, the registers 502 and comparators 506 of Fig. 17A are replaced by associative memory portions 514 which form an associative memory device 512.

The associative memory portion 514 is provided with a memory and a comparing circuit, and stores data of a predetermined length, and compares the stored data with inputted data. A search for search data is effected by storing search data in the associative memory portion 514, inputting data to be searched which is held in the shift register 504, and comparing these data. The terminals which output the comparison results of the respective associative memory portions 514 are respectively connected to a match line 516. Before the respective associative memory portions 514 compare the data, the match line 516 is charged in advance (so-called "precharging") to a high level by an unillustrated external circuit. Each of the associative memory portions 514 compares the stored search data and the data to be searched which is held in the shift register 504, and sets the match line 516 to a low level (discharges the charge) in cases in which the data do not match. Accordingly, the match line 516 is maintained at a high level only when the comparison results of all of the associative memory portions 514 are "matching". Therefore, discovery of search data is detected based on the level of the match line 516.

However, in the search circuit 510 illustrated in Fig. 17B, when data of an undefined length (hereinafter, "variable-length data") is searched for as search data, it is necessary to match the length of data which can be stored by the shift register 504 to the maximum length of the search data, and to ensure that the number of associative memory portions 514 of the associative memory device 512 corresponds to the maximum length. Further, when the search data is short, there are unnecessary associative memory circuits (i.e., circuits not contributing to the data search). A drawback arises in that these unnecessary associative memory circuits uselessly consume electric power.

Further, the number of unnecessary associative memory circuits varies in accordance with the length of search data. Therefore, in order to prevent the comparison results outputted from the unnecessary associative memory circuits from influencing the results of searching of the search circuit 510, it is necessary, for example, to add circuits effecting Don't Care (DC) processing in which "matching" comparison results are compulsorily outputted from the unnecessary associative memory circuits, or in which the outputted comparison results are ignored and the number of relevant associative memory circuits is varied in accordance with the length of the search data. However, for associative memory devices having such a DC processing function, it is difficult to design an integrated circuit structure having a high degree of integration as compared with ordinary associative memories, and as a result, it is difficult for the apparatus to be made compact. Accordingly, various drawbacks arise when a search for variable-length search data is to be effected by using associative memories.

Moreover, a characteristic drawback of the AM method in a case in which a search for fixed-length data of a set length is effected is that, because data to be searched is successively inputted to the shift register 504 and searching is effected, the search time increases in proportion to the length of the data to be searched. For example, in a case in which the data to be searched is very large, as in the case of searching in a data base or the like, an extremely long search time is required.

In recent years, multimedia technology has become advanced, and there has been a need to handle large amounts of various data such as image data, voice data, document data, programs and the like for various systems. It is very advantageous from the standpoints of cost and processing speed to effect processes, such as storing large amounts of data in a storing device, transmitting the data and the like, after the data has been compressed. Consequently, the importance of data compression techniques has rapidly increased.

Various conventional data compression techniques have been proposed and can be roughly classified into two types: lossy compression and lossless compression. Although the compression rate in lossy compression is high, information is lost in the processes of compressing data and restoring the compressed data. Therefore, lossy compression can only be applied to specific fields. On the other hand, although the compression rate of lossless compression is low, information is not lost in the processes of data compression and restoration of the compressed data. Because the restored data completely matches the original data before compression, lossless compression has a wide range of applicability.

As one type of lossless compression, in 1977, Lempel and Ziv proposed a universal compression algorithm LZ77 (hereinafter referred to as simply "LZ77") based on a dictionary technique. The compression rate of LZ77 is high as compared with entropy codes such as the well-known Huffman code, and LZ77 is a useful compression method. To basically summarize LZ77, repeat data which is included among original data is searched for. The repeat data is replaced by another code (a pointer indicating the position of the same data which has already appeared, and the data length of the repeat data), and the data is compressed by eliminating redundancy. In LZ77, it is relatively easy to restore the compressed data to the original data before compression. However, a drawback arises in that, because repeat data is also variable-length data whose length is undefined, much work is required in searching for the repeat data when the data is compressed.

There are several conventional software algorithms which effect data compression based on the ideas of LZ77. In these software algorithms, original data is converted into tree structure data, and a search for the repeat data is effected. However, because the algorithm for converting data into tree structure data is extremely complicated, much time is required for processing and a large load is placed on the CPU. In order to solve this drawback, a method has been proposed in which these processes effected by software are replaced and executed by hardware. However, as in the above case, because the algorithm is complicated, this method cannot be realized easily. Further, the conversion into tree structure data has a drawback in that the time required for compression is not uniform because the tree structures differ in accordance with the contents of the original data.

Accordingly, the invention provides a data search device comprising: storage apparatus for storing data to be searched, the data comprising a sequence of data segments of predetermined bit length, said apparatus comprising a plurality of ordered storage units, each capable of storing a data segment; a plurality of comparing means, each associated with a respective storage unit, for outputting a matching signal when a data segment stored in a storage unit matches an inputted data segment; and control means for fetching in turn a succession of data segments from search data comprising a plurality of data segments, and for inputting a fetched search data segment to each of said plurality of comparing means adjacent to a comparing means which outputted said matching signal for the preceding data segment.

Thus the storage apparatus typically comprises a linear array of storage units or cells, each of which can store a data segment. Generally a data segment will represent a single character (eg an 8-bit ASCII code). The storage apparatus contains the data to be searched (the search text), whilst the data to be located (the search string) is fed in a data segment at a time to the comparing means (note that search string and search text are not limited to literal data, but may be numerical, image, or any other form of data). Once a match is found for any particular data segment, for the next data segment only adjacent matches are looked for - ie comparison with the rest of the search text is effectively disabled. This is an effective and economical way of locating sequences from the search string within the search text. The data search device can therefore effect data searching at high speed.

Typically the data search device is incorporated into a data compression device, wherein the control means fetches in turn data segments from the data string to be compressed, and inputs the fetched data segment to the comparing means. If a matching signal is produced by at least one of the comparing means, the next data segment is inputted only to the comparing means adjacent to the comparing means which outputted a matching signal; or if a matching signal is not produced by at least one of the comparing means, then dependent on the number of preceding data segments that were matching, either the inputted data segment(s), or a predetermined code representative of the data segments are output as compressed data. The fetched data segment is then stored in the next storage unit.

There are many data compression codes, such as LZ77, which operate by effectively eliminating repetitions in the data to be compressed. These can be implemented using the data search device, by storing past data in the storage apparatus, and then trying to locate current data sequences in this past data. If no match or just a short match is obtained, then the current data is output unchanged. However, if a repeat sequence of sufficient length is located (typically over two data segments in length), then this can be replaced by a reference to its earlier occurrence. Such references to earlier sequences can be much more compact than the sequences themselves, and so lead to effective data compression. The current data is then added to the storage apparatus, so that it to can be used as a search text for future data segments.

Once the end of a repeat sequence has been detected, the terminating data segment (ie the data segment immediately following the last matching data segment) can be output unchanged However, since such a terminating data segment may itself represent the start of a new sequence, it is preferred that if the preceding data segment outputted a matching signal, so that the current data segment was only inputted to some of the comparing means, and none of these produced a matching signal, the same data segment is retained as the next data segment. Thus this time the data segment is inputted to all of the comparing means, rather than just those adjacent to comparing means which previously output a matching signal. Although this does require extra processing (there are two comparison operations for the data segment), it leads to more efficient compression, since it avoids the need for there to be a spacing of at least one data segment between successive matching sequences.

Although the size of the storage apparatus does not affect the searching time, since searching is conducted in parallel, it does affect the overall complexity and cost of the device and degree of compression obtained. For a storage apparatus of limited size, preferably the storage units are logically ordered as a circular (ring) buffer. Thus the storage units are filled up in sequence (eg in order of increasing or decreasing address), and when all have been occupied, the ones filled first are overwritten.

In a preferred embodiment, the control means is provided with a counting means for counting the number of successive data segments for which a matching signal is outputted from a comparing means, said predetermined code being formed by using the count of the counting means and the identity of the storage unit corresponding to the comparing means which outputted the last matching signal. This allows compression to be performed in accordance with LZ77 for example. The degree of data compression obtained can be enhanced by varying the number of bits of said predetermined code in accordance with the number of storage units currently storing data segments. Thus if only the low number storage units are currently occupied then these can be distinguished with fewer bits than would be required for the full storage apparatus.

In a preferred embodiment the predetermined code includes a distance code representative of the distance between the storage unit which stores the fetched data segment when the last matching signal was outputted, and the storage unit corresponding to the comparing means which outputted the last matching signal, and said control means varies the number of bits of said distance code in accordance with a magnitude of said distance. This slight modification (ie transmitting the distance to rather than the identity of the last matching storing unit) will in general require slightly fewer bits, and so provide greater data compression. Moreover, if a plurality of matching signals are obtained for the previous data segment but none for the current data segment, the control means preferably selects from the storage units corresponding to the comparing means which outputted matching signals the one which produces the smallest distance. Again, the small distance can be compactly represented, thereby helping to maximise data compression.

It is also preferred that the data compression device further comprises invalidation control means for invalidating a matching signal outputted from a comparing means if the storage unit corresponding to said comparing means is included in a region of the storage apparatus in which data segments have not yet been stored. Preferably the device further comprises holding means for identifying which parts of the storage apparatus have been used for storing data segments. The invalidation control means and the holding means are advantageous because the decompression apparatus has no knowledge of these regions, and so could not reconstruct "repeat" sequences located within them. Of course, it might be possible to define the initial contents of the storage apparatus, such as all zeros, in which case the invalidation would be unnecessary, but this would require resetting the data compression apparatus before use, and this has its own costs in terms of power consumption etc.

The data compression device can also be readily adapted to perform the corresponding decompression. In this case, the control means causes said plurality of storage units to temporarily store data which has already been restored from said compressed data, and by using said stored data, said control means restores compressed data following on from the compressed data which has already been restored.

The invention further provides a data compression method for compressing an input data string comprising a sequence of data segments, using storage apparatus having a plurality of ordered storage units each capable of storing one data segment, and a plurality of comparing means each associated with a storage unit, the comparing means outputting a matching signal when the data inputted thereto matches the data segment in the associated storage unit, said data compression method comprising the steps of: (a) fetching data segments in turn from the input data string; (b) inputting the fetched data segment to the comparing means adjacent to the comparing means which outputted a matching signal for the previous data segment, or to all the comparing means if no matching signal was produced for the previous data segment, and if a matching signal is not produced by at least one of the comparing means, then dependent on the number of preceding data segments that were matching, outputting as the compressed data either the inputted data segment(s), or a predetermined code representative of the data segments; (c) and storing the fetched data segment in the next storage unit.

As discussed above, it is preferred that if no matching signal was outputted for the current data segment, but a matching signal was outputted by the preceding data segment, step (b) is repeated before progressing to step (c).

The data search device can be formed from a storing device having a plurality of storing means for storing unit data formed from data of a predetermined bit length, and having a plurality of comparing means, which are provided so as to correspond to the storing means, for outputting a matching signal when unit data which is stored in the storing means matches inputted unit data, the storing device storing data to be searched, which has been divided into a plurality of unit data, in a plurality of storing means of the storing device in a predetermined order; and control means fetching a specific unit data from search data formed by a predetermined number of unit data and inputting the specific unit data to each of the plurality of comparing means of the storing device, moving a fetching position at which unit data is fetched from the search data and fetching unit data, inputting the fetched unit data to a comparing means, and repeating aforementioned operations only in a comparing means adjacent to the comparing means which has outputted the matching signal so as to search for data.

In data searching, as represented, for example, by a search of a character string in a data base or the like, there are many search data which are variable-length data whose lengths are undefined, and obviously, whose lengths are short compared to the length of the data to be searched. The operations of comparing the unit data stored in the storing means and the inputted unit data are effected in parallel in each of the comparing means. The search data is divided into unit data and is inputted in order. The length of the unit data (bit length) can be 8 bits in a case in which, for example, the search data and the data to be searched are character data represented by an ASCII code or an ISO code. The length of the unit data can be 16 bits for character data in Japanese, including kanji.

The processing time necessary for searching (specifically, the number of times that the comparison operation is repeated) varies in accordance with the length of the search data. As compared with a conventional case in which the number of times the comparison operation is repeated varies in accordance with the length of the data to be searched, a data search can be effected in an extremely short time, especially in cases in which the length of the data to be searched is very long.

Further, even if the search data is variable-length data of an undefined length, only the number of times that the unit data is inputted to the comparing means varies in accordance with the length of the search data. There is no need to vary the circuit structure to match the maximum value of the length of the search data.

In cases in which the length of the search data is shorter than the maximum value, the conventional art requires use of unnecessary comparators, the number of which varies in accordance with the length of the search data, or the use of associative memory cells or RAM cells to which are added circuits effecting DC (Don't Care) processing for invalidating comparison results of an associative memory portion. However, with the above approach, if the number of search data varies, only the number of times the unit data is inputted to the comparing means varies. Therefore, there is no need for associative memory cells or RAM cells to which circuits which effect DC processing are added. Accordingly, the storing device of the data search device can be structured by using ordinary associative memory cells, RAM cells or the like having a high degree of integration, and the device can be made more compact.

Except for special cases such as the data to be searched and the search data being formed of all of the same unit data, the number of comparing means in which a comparison operation is effected decreases as inputting of the unit data to the comparing means is repeated. Outputting of the matching signal and comparison of the unit data are not effected at comparing means adjacent to the comparing means which has not outputted the matching signal. Therefore, processing can be effected by consuming an extremely small amount of electric power, and the amount of electric power consumed can be reduced especially in cases in which the length of the search data is very long.

The data search device may be structured such that the storing device stores the data to be searched, which has been divided into unit data, in the plurality of storing means in ascending or descending order of addresses given to the plurality of storing means, and the control means fetches the unit data while moving a position, from which the unit data is fetched, per the predetermined bit length from a beginning to an end (or vice versa) of the search data, and the control means outputs the fetched unit data only to a comparing means adjacent to the comparing means which has outputted the matching signal.

A data compression device may be formed comprising: a storing device having a plurality of storing means for storing unit data formed from data of a predetermined bit length, and having a plurality of comparing means, which are provided so as to correspond to the storing means, for outputting a matching signal when unit data which is stored in the storing means corresponds to inputted unit data; and control means fetching a specific unit data from original data, which is formed by a predetermined number of unit data, and inputting the specific unit data to each of the plurality of comparing means of the storing device, and thereafter effecting operation such that in a case in which the matching signal has been output, the fetched unit data is stored in the storing means in one of ascending order and descending order of addresses given to the storing means, and thereafter, unit data adjacent to the fetched unit data is fetched and inputted only to a comparing means adjacent to the comparing means which has output the matching signal, and in a case in which the matching signal has not been output, the fetched unit data is output as compressed data and is stored in the storing means in one of ascending order and descending order of the addresses, and thereafter, unit data adjacent to the fetched unit data is fetched and inputted to each of the comparing means, and in a case in which the matching signal is no longer output after having been outputted, unit data, which had been stored in the storing means while the matching signal was being outputted, are replaced with a predetermined code and the code is output as compressed data, and the fetched unit data are output as compressed data and the compressed data is stored in the storing means in one of ascending order and descending order of the addresses, and unit data adjacent to the fetched unit data is fetched and inputted to each of the comparing means, the control means repeating aforementioned operations so as to compress the original data into compressed data, and outputting the compressed data.

In such a system unit data is fetched from original data, which is formed of a predetermined number of unit data, and is inputted to the comparing means of the storing device. Thereafter, storing the fetched unit data in ascending order or descending order of the addresses given to the storing means is repeated. Accordingly, the original data is fetched per unit data, and is compared so as to determine whether the fetched unit data matches unit data already stored in the storing means. Further, after a specific unit data is fetched from the original data and is inputted to each of the plurality of comparing means, respectively different processes are repeated for a case in which the matching signal is outputted, a case in which the matching signal is not outputted, and a case in which the matching signal is no longer outputted after having been outputted, and the original data is compressed.

Namely, in the case in which the matching signal is not outputted, the unit data inputted to the comparing means does not match unit data which has already been stored in the storing means. Therefore, the unit data is outputted as raw data which cannot be compressed and is stored in the storing means. Thereafter, unit data adjacent to the previously-mentioned unit data is fetched and is inputted to the respective comparing means. Accordingly, comparison is effected in each of the plurality of comparing means so as to determine whether the unit data adjacent to the previously-mentioned unit data matches unit data which has already been stored in the storing means.

Further, in the case in which the matching signal is outputted, the unit data inputted to the comparing means matches unit data already stored in the storing means, and it can be determined that the inputted unit data is data ("repeat data") existing in a plurality of places of the original data. As a result, the unit data is not outputted as raw data, and is stored in the storing means. Thereafter, the unit data adjacent to the previously-mentioned unit data is fetched, and is compared at the comparing means adjacent to the comparing means which outputted the matching signal.

The above corresponds to a comparison for determining whether unit data, which is adjacent to unit data which matches unit data already stored in the storing means, is stored in the storing means corresponding to the comparing means adjacent to the comparing means which outputted the matching signal. Accordingly, when the matching signal is continuously outputted, the plurality of data corresponding to the matching signal are continuous repeat data, and it is detected that the repeat data is formed from the plurality of unit data.

Further, when the matching signal is no longer outputted after having been outputted, it can be determined that the end of the detected repeat data has been detected. As a result, the unit data stored in the storing means while the matching signal was being outputted (i.e., the repeat data) is replaced by a predetermined code and is outputted as compressed data. The fetched unit data is outputted as raw data and is stored in the storing means, and the unit data adjacent to the fetched unit data is fetched and is inputted to the respective comparing means.

By repeating the above processes, repeat data which is included in the original data is replaced by a predetermined code, and compressed data is outputted. As is clear from the above description, the compression of the original data is completed by the original data being divided into unit data and being inputted in order. Therefore, data compression can be effected in a fixed time corresponding to the length of the original data and in a time which is extremely short as compared with a case in which the original data is converted into tree structure data and a search for repeat data is effected.

In the above description, in a case in which the matching signal is no longer output after having been outputted and it is determined that the end of the detected repeat data has been detected, the unit data inputted to the comparing means is outputted as compressed data and is stored in the storing means in either ascending order or descending order of the addresses, and unit data adjacent to the previous unit data is fetched and is inputted to the respective comparing means. Therefore, a drawback arises in that when the unit data adjacent to the end of the detected repeat data is a different repeat data, there are cases in which this unit data cannot be detected as repeat data and all of the repeat data included in the original data cannot be detected.

In order to solve this drawback, it is preferable that, when the matching signal is no longer output after having been outputted, the unit data which is stored in the storing means while the matching signal is being output is replaced by a predetermined code and is outputted as compressed data, and fetched unit data is again inputted to each of the comparing means. Accordingly, even if within the original data there are different repeat data adjacent to each other, both of the adjacent repeat data can be detected. Therefore, all of the repeat data included in the original data can be detected, and the compression rate of the original data is improved even more.

Preferably, after unit data has been stored in all of the storing means of the storing device, the control means returns the address of the storing means, in which the unit data is written, to the beginning or the end, and stores unit data. Compression of original data implies that it is not always necessary to store all of the original data in the storing means. Therefore, by using the storing means of the storing device as a so-called ring or circular buffer, the number of storing means of the storing device, i.e., the storage capacity, can be reduced.

It is preferable that the control means is provided with a counting means for counting a number of times the matching signal is outputted from a comparing means, the predetermined code being formed by using the number of times counted by the counting means and an address of the storing means corresponding to comparing means which outputted the matching signal. Thus, in a case in which repeat data is replaced, in accordance with the aforementioned LZ77, by a predetermined code which expresses a pointer indicating the position of the same data which has already appeared and the data length of the repeat data, the counting means counts the number of times the matching signal is outputted from the comparing means. The predetermined code can be formed by using the number of times counted by the counting means and the address of the storing means corresponding to the comparing means which outputted the matching signal.

The unit data fetched from the original data is stored in order in the storing means of the storing device. Therefore, even if the storing means of the storing device are used as a ring buffer as described above, when compression processing begins, there are storing means in which unit data is not stored. When unit data is inputted to the comparing means corresponding to these storing means, there is the possibility that a matching signal will be outputted accidentally because the data stored in the storing means is undefined.

In order to solve this drawback, an invalidation control means is provided, and when the matching signals are outputted from a comparing means, on the basis of a boundary address between a region in which unit data has been stored and a region in which unit data has not been stored in the storing device and on the basis of an address of the storing means corresponding to the comparing means, the invalidation control means invalidates a matching signal outputted from the comparing means when the storing means corresponding to the comparing means is included in the region in which the unit data has not been stored. Accordingly, matching signals which are outputted accidentally can be invalidated.

Further, there may be provided holding means which correspond to the storing means of the storing device and which hold information expressing whether unit data fetched from original data has been stored in the storing means, and invalidation control means which correspond to the storing means and which invalidate, on the basis of information held in the holding means, matching signals outputted from the comparing means, when data fetched from the original data has not been stored in the storing means. However, if it is necessary to provide holding means and invalidation control means for each storing means, the degree of integration decreases slightly when an integrated circuit structure is designed for the storing device.

It is preferable that the control means varies the number of bits of the predetermined code in accordance with the number of storing means storing the unit date. As described above, the predetermined code may be, for example, structured by a pointer which indicates the position of the same data which has already appeared, and a code which represents the data length of the repeat data. When the number of storing means storing unit data is small, both the pointer information and the data length information can be represented by a number of bits which is small as compared to a case in which the number of storing means storing unit data is large. Accordingly, the compression ratio of the original data can be further improved by varying the number of bits of the predetermined code in accordance with the number of storing means storing unit data, or more specifically, by varying the number of bits of the predetermined code such that the number of bits of the predetermined code is small when the number of storing means storing unit data is small.

Further, the predetermined code can be structured so as to include a distance code representing the distance between the storing means, in which unit data was stored while the matching signal was being outputted, and the storing means, which corresponds to the comparing means which outputted the matching signal. (This distance can also be included in the pointer indicating the position of the same data which has already appeared.) For these storing means as well, if the distance therebetween is small, the distance can be expressed by a small number of bits. Further, in general, there is a high probability that repeat data which is included in the original data are at relatively close positions in the original data, although this depends on the type of original data as well.

As a result, in a case in which the predetermined code is structured so as to include a distance code, it is preferable that the control means varies the number of bits of the distance code in accordance with the magnitude of the distance. In a case in which matching signals are no longer output after having been outputted from the plurality of comparing means, it is preferable that the control means forms the distance code on the basis of a distance between the storing means, among the plurality of storing means corresponding to the plurality of comparing means, which has the smallest distance from the storing means in which the unit data was stored while the plurality of matching signals were being outputted, and the storing means in which the unit data was stored.

A case in which matching signals are no longer outputted after having been outputted from a plurality of comparing means is a case in which the same repeat data are stored in each of a plurality of storing means. In accordance with the above description, the control means selects the storing means having the smallest distance from the storing means in which unit data was stored while the matching signals were being outputted, from among the plurality of storing means which stored the same repeat data. The control means forms the distance code on the basis of the distance between the selected storing means and the storing means in which the unit data was stored.

Accordingly, if the number of bits of the distance code is varied in accordance with the magnitude of the distance, or more specifically, if the number of bits of the distance code is varied so as to become small when the distance is small, the compression ratio of the original data can be further improved due to the multiplier effect of the fact that there is a high probability that the repeat data included in the original data are at relatively close positions in the original data.

It is possible to perform decompression by having the control means cause the plurality of storing means of the storing device to temporarily store original data which has already been restored from the compressed data, and by using the stored original data to restore compressed data, which is continuous with the compressed data which has already been restored to original data, to original data.

A data compression method may be used involving using a storing device having a plurality of storing means for storing unit data formed from data of a predetermined bit length, and having a plurality of comparing means, which are provided so as to correspond to the storing means, for outputting a matching signal when unit data which is stored in the storing means corresponds to inputted unit data, the data compression method comprising the steps of: fetching a specific unit data from original data, which is formed by a predetermined number of unit data, and inputting the specific unit data to each of the plurality of comparing means of the storing device, and thereafter, effecting operation such that in a case in which the matching signal has been output, the fetched unit data is stored in the storing means in one of ascending order and descending order of addresses given to the storing means, and thereafter, unit data adjacent to the fetched unit data is fetched and inputted only to those comparing means adjacent to the comparing means which outputted the matching signal, and in a case in which the matching signal has not been output, the fetched unit data is output as compressed data and is stored in the storing means in one of ascending order and descending order of the addresses, and thereafter, unit data adjacent to the fetched unit data is fetched and inputted to each of the comparing means, and in a case in which the matching signal is no longer output after having been outputted, unit data, which had been stored in the storing means while the matching signal was being outputted, are replaced with a predetermined code and the code is output as compressed data, and the fetched unit data are output as compressed data and the compressed data is stored in the storing means in one of ascending order and descending order of the addresses, and unit data adjacent to the fetched unit data is fetched and inputted to each of the comparing means. The aforementioned operations are repeated so as to compress the original data into compressed data.

Therefore data compression can be effected in a fixed time corresponding to the length of the original data and in a time which is extremely short as compared with the conventional art.

Further, when the matching signal is no longer output after having been outputted as described above, the unit data which was stored in the storing means while the matching signal was being outputted may be replaced by a predetermined code and is outputted as compressed data, and fetched unit data is inputted again to each of the comparing means. Therefore, all of the repeat data included in the original data can be detected, and the compression rate of the original data may be improved even more.

To recap therefore, the data search device includes a storing device having a plurality of storing means for storing unit data and a plurality of comparing means outputting a matching signal when unit data stored in the storing means matches inputted unit data. Data to be searched, which is formed of a plurality of unit data, is divided into unit data, and the unit data are stored in a predetermined order in the storing means. A specific unit data is fetched from search data, which is formed of a predetermined number of unit data, and is inputted to each of the plurality of comparing means of the storing device. Thereafter, the position at which unit data is fetched from the search data is moved, and unit data is fetched. The fetched unit data is inputted to a comparing means which is adjacent to the comparing means which outputted the matching signal. These operations are repeated so as to search for data. Therefore, a data search can be effected at high speed.

The data search device can be incorporated into a data compression device, in which unit data is fetched from original data, which is formed of a predetermined number of unit data, and is inputted to the comparing means of the storing device. Thereafter, the fetched unit data is stored in the storing means in either ascending order or descending order of the addresses given to the storing means. These operations are repeated. When the matching signal is no longer output after having been outputted from the comparing means, the unit data which was stored in the storing means while the matching signal was being outputted is replaced by a predetermined code and is outputted as compressed data. Therefore, data compression can be effected at high speed.

As a further refinement, when the matching signal is no longer output after having been outputted, instead of the fetched unit data being outputted as compressed data, the fetched unit data is again inputted to the respective comparing means. Therefore, all of the repeat data, including the original data, can be detected, and the compression rate of the original data can be improved even further.

Various embodiments of the invention will now be described in detail by way of example, with reference to the following drawings:

Fig. 1 is a block diagram illustrating a schematic structure of a microcomputer.

Fig. 2 is a block diagram illustrating a schematic structure of a character string search device relating to the first embodiment.

Fig. 3 is a circuit diagram illustrating an example of a structure of a unit cell of an associative memory.

Fig. 4 is a circuit diagram illustrating a structure of a precharge circuit.

Fig. 5 is a flowchart for explaining the operation of a main controller in the first embodiment.

Figs. 6A through 6D are conceptual views for explaining a search operation in the first embodiment.

Fig. 7 is a circuit diagram illustrating another example of a structure of the unit cell of the associative memory.

Fig. 8 is a block diagram illustrating a schematic structure of a character string search device of a second embodiment.

Fig. 9 is a conceptual view for explaining the comparison of character data per bit in the second embodiment.

Fig. 10 is a block diagram illustrating a schematic structure of a character string compression controller of a third embodiment.

Fig. 11 is a flowchart explaining the operation of the third embodiment.

Figs. 12A through 12H are conceptual views for explaining compression operations in the third embodiment.

Figs. 13A through 13H are conceptual views for explaining compression operations in the third embodiment.

Fig. 14 is a flowchart explaining the operation of a fourth embodiment. Fig. 15 is a block diagram illustrating a schematic structure of a character string compression controller of a fifth embodiment.

Fig. 16 is a circuit diagram illustrating a structure of a garbage control circuit added to a character string search circuit relating to the fifth embodiment.

Fig. 17A is a block diagram illustrating a schematic structure of a conventional data search circuit; Fig. 17B is a block diagram illustrating a schematic structure of a search circuit in which a portion of the circuit in Fig. 17A is replaced by an associative memory.

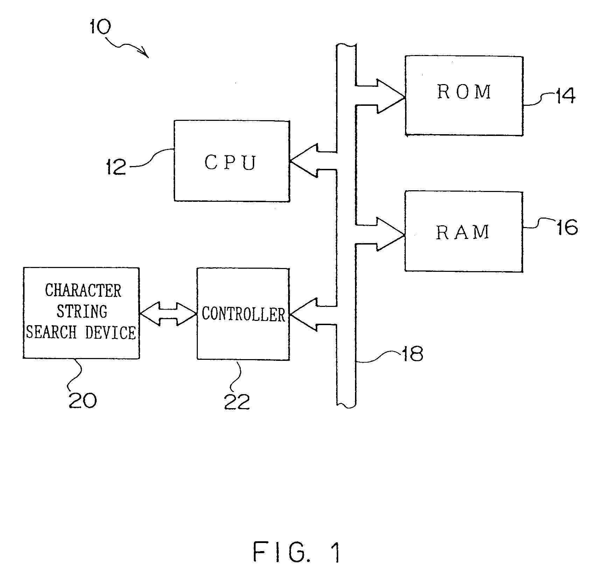

A portion of the structure of a microcomputer 10 is illustrated in Fig. 1. The microcomputer 10 includes a CPU 12, a ROM 14, and a RAM 16 which are connected via a bus 18 formed from address busses, data busses, control busses and the like. Further, the microcomputer 10 is equipped with a character string search device 20. The character string search device 20 is connected to the bus 18 via a controller 22 which controls the operation of the character string search device 20.

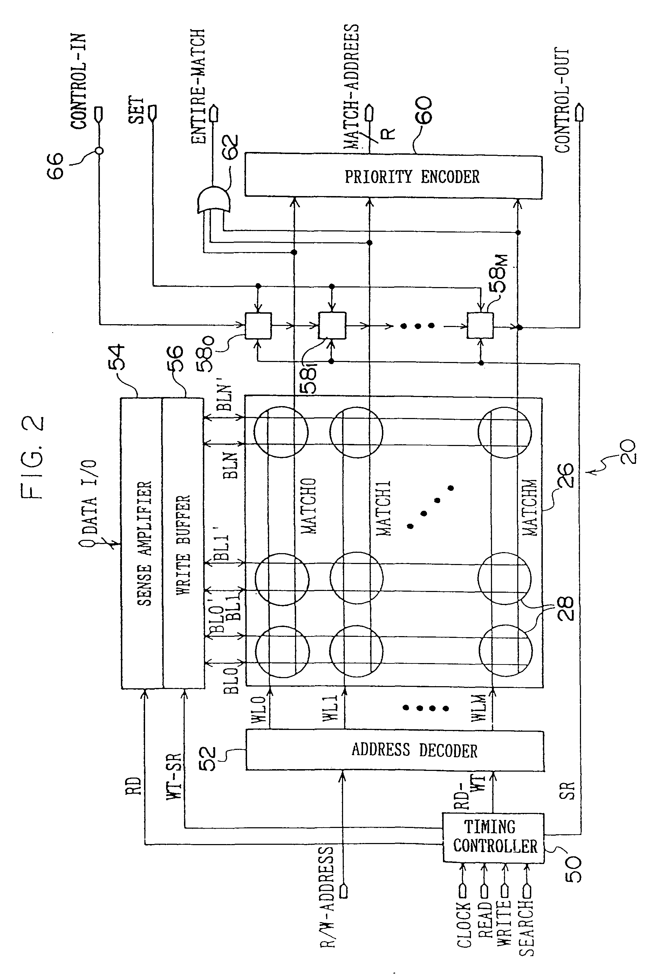

As illustrated in Fig. 2, the character string search device 20 includes an associative memory cell array 26 in which a plurality of associative memory cells (unit cells) 28, represented by circles in Fig. 2, are arranged in matrix form. (M+1) word lines WL0 through WLM, (M+1) match lines MATCH0 through MATCHM, and (N+1) groups of bit line pairs BL0,BL0' through BLN,BLN' are respectively arranged in matrix forms in the associative memory cell array 26. Each of the associative memory cells 28 is connected to one of the word lines WL0 through WLM, one of the match lines MATCH0 through MATCHM, and one of the bit line pairs BL0,BL0' through BLN,BLN', respectively.

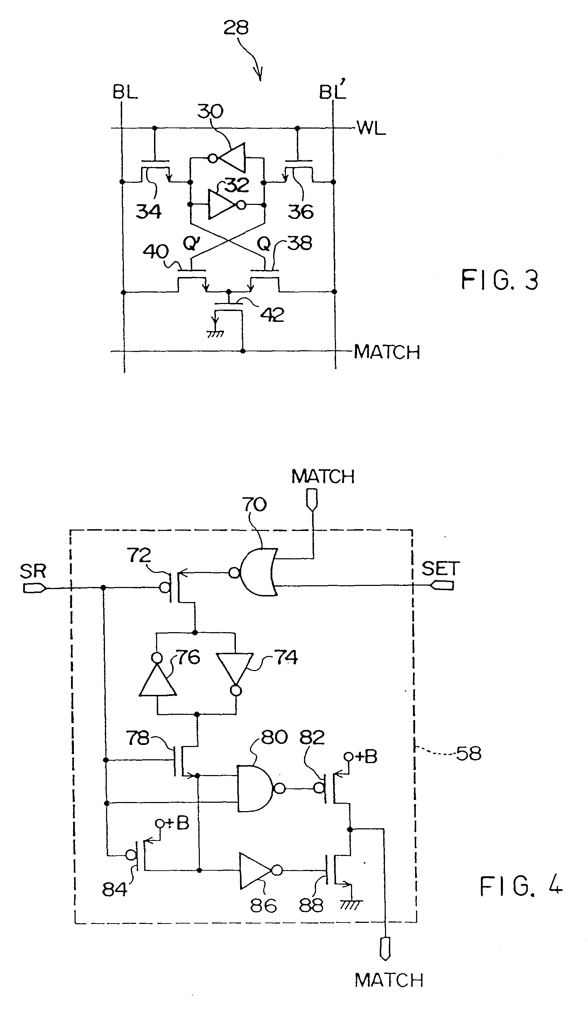

The respective associative memory cells 28 each have the same structure. As illustrated in Fig. 3, an associative memory cell 28 includes two NOT circuits 30, 32 whose respective input terminals and respective output terminals are connected together. A storage circuit (SRAM type) which stores data of one bit is formed by this loop of the NOT circuits 30, 32. The output terminal of the NOT circuit 30 is connected to the source of an N channel type MOSFET 34, and the output terminal of the NOT circuit 32 is similarly connected to the source of an N channel type MOSFET 36. The gates of the MOSFETs 34, 36 are respectively connected to the word line WL.

Further, the drains of the MOSFETs 34, 36 are respectively connected to the bit lines BL,BL'. When data of 1 bit is written into the associative memory cell 28 (referred to hereinafter as the "write" mode), the word line WL becomes high level, the bit line BL becomes a level corresponding to the write data D (high level when D is "1", and low level when D is "0"), and the bit line BL' becomes a level which is the inverse of the level of the bit line BL (low level when the bit line BL is high level, and high level when the bit line BL is low level). Accordingly, the MOSFETs 34, 36 are turned on, and the data supplied via the bit line pair BL or BL' is held in the loop of the NOT circuits 30, 32. Here, the data stored in the associative memory cell 28 is readable (hereinafter, "read" mode).

The output terminal of the NOT circuit 30 is connected to the gate of the MOSFET 38, and the output terminal of the NOT circuit 32 is connected to the gate of the MOSFET 40. Data Q', which is the data D inverted, is outputted from the NOT circuit 32, and data Q (=D), which is the data Q' inverted, is outputted from the NOT circuit 30. The drains of the MOSFETs 38, 40 are respectively connected to the bit lines BL',BL, and the sources thereof are connected to the gate of a MOSFET 42. The drain of the MOSFET 42 is connected to the match line MATCH, and the source thereof is grounded.

In the present embodiment, the number of associative memory cells 28 which are connected to the same word line and match line matches the number of bits expressing one character forming the character string to be searched (e.g., 8 bits for ASCII code, ISO code, or the like). Character data for one character is stored by a plurality of associative memory cells 28 which are connected to the same word line and match line (hereinafter referred to as an associative memory cell row). Further, in the associative memory cell array 26, an address is given to each associative memory cell row.

The loops of the NOT circuits 30, 32 of the respective associative memory cells 28 forming a single associative memory cell row effectively consititute storing means, and the MOSFETs 38, 40, 42 of the respective memory cells 28 forming a single associative memory cell row effectively constitute comparing means.

As illustrated in Fig. 2, the character string search device 20 is equipped with a timing controller 50. Operational modes of the character string search device 20 are the "read" mode in which data stored in the associative memory cell array 26 is read, the "write" mode in which data is written into the associative memory cell array 26, and a "search" mode in which a search with respect to data stored in the associative memory cell array 26 is effected. The timing controller 50 is connected to the controller 22. The above-described operational modes are switched in accordance with a read designation READ, a write designation WRITE, and a search designation SEARCH which are respectively inputted to the timing controller 50 from the controller 22.

A system clock CLOCK is inputted from the controller 22 to the timing controller 50. Four clocks (clock RD, clock WT-SR, clock RD-WT, clock SR) which are synchronous with the system clock CLOCK are generated and outputted in accordance with the three operational modes. The clock RD-WT is outputted during "read" and "write" to an address decoder 52 which is connected to the timing controller 50, so as to operate the address decoder 52. The address decoder 52 is connected to the controller 22. The address of the associative memory cell row, at which reading or writing of data is effected, is designated from the controller 22. The word lines WL0 through WLM are connected to the address decoder 52. The word line of the associative memory cell row corresponding to the designated address becomes a high level.

A sense amplifier 54 and a write buffer 56 are connected to the timing controller 50. During "read", the clock RD is outputted to the sense amplifier 54 so as to operate the sense amplifier 54. During "write" and "search", the clock WT-SR is outputted to the write buffer 56 so as to operate the write buffer 56. The bit line pairs BL0,BL0' through BLN,BLN' are respectively connected to the sense amplifier 54 and the write buffer 56. Further, the sense amplifier 54 and the write buffer 56 are connected to the controller 22.

During "read", the sense amplifier 54 amplifies the levels (which represent read data) of the bit line pairs BL0,BL0' through BLN,BLN', which are varied in accordance with data stored in the respective associative memory cells 28 of the associative memory cell rows, and outputs the levels to the controller 22. During "write" and "search", the write buffer 56 varies the levels of the bit line pairs BL0,BL0' through BLN,BLN' in accordance with data which is inputted from the controller 22 and stored in the buffer (i.e., the write buffer 56 drives the bit line pairs). During "search", the address decoder 52 is not operated and all of the word lines WL0 through WLM become low level, as described above. Therefore, the levels of the bit line pairs which are varied in accordance with the search data are not fetched at the associative memory cells 28, i.e., search data is not written into the associative memory cells 28.

(M+1) precharge controllers 58₀ through 58_{M} are respectively connected to the timing controller 50. During "search" operation, the clock SR is outputted to the precharge controllers 58₀ through 58_{M} so that the precharge controllers 58₀ through 58_{M} are respectively operated. The precharge controller 58₀ is connected to the controller 22 via a terminal 66 and is connected to the match line MATCH0. The precharge controller 58₁ is connected to match line MATCH0 and match line MATCH1. The precharge controllers from precharge controller 58₂ on are connected, in the same way as the precharge controller 58₁, to the two adjacent match lines. Further, the precharge controller 58_{M}is connected to the controller 22 via the match line MATCHM.

The precharge controllers 58₀ through 58_{M} have the same structure. As illustrated in Fig. 4, the precharge controller 58 is equipped with a NOR circuit 70. One of the input terminals of the NOR circuit 70 is connected to the match line of the previous stage (for example, match line MATCH0 for precharge controller 58₁). However, the precharge controller 58₀ is connected to the controller 22 via the terminal 66, and a low level signal is always input from the controller 22 as an input signal CONTROL-IN. The other input terminal of the NOR circuit 70 is connected to the controller 22. The signal SET (see Fig. 2), which is usually low level and which becomes high level when all of the match line MATCH0 through MATCHM are charged (precharged) to a high level, is inputted to the respective precharge controllers 58₀ through 58_{M} from the controller 22.

The input terminal of a NOT circuit 74 and the output terminal of a NOT circuit 76 are connected to the drain of the MOSFET 72. The output terminal of the NOT circuit 74 and the input terminal of the NOT circuit 76 are respectively connected to the drain of an N channel type MOSFET 78. Accordingly, a storage circuit is formed by the NOT circuits 74, 76. The gate of the MOSFET 78 is connected to the timing controller 50 so that the clock SR is inputted during "search". The source of the MOSFET 78 is connected to one of the input terminals of a NAND circuit 80. The other input terminal of the NAND circuit 80 is connected to the timing controller 50.

The output terminal of the NAND circuit 80 is connected to the gate of a P channel type MOSFET 82. The source of the MOSFET 82 is connected to an unillustrated power source, and the drain thereof is connected to the match line of the subsequent stage (for example, match line MATCH1 for precharge controller 58₁). Further, the timing controller 50 also is connected to the gate of a P channel type MOSFET 84. The source of the MOSFET 84 is connected to an unillustrated power source, and the drain thereof is connected to the input terminal of a NOT circuit 86. The input terminal of the NOT circuit 86 is also connected to the source of the MOSFET 78. The output terminal of the NOT circuit 86 is connected to the gate of an N channel type MOSFET 88. The source of the MOSFET 88 is connected to the match line of the aforementioned subsequent stage, and the drain thereof is grounded.

The match lines MATCH0 through MATCHM are respectively connected to a priority encoder 60. As will be described later, an associative memory cell row, whose match line becomes high level after a comparison operation has been effected in the "search" mode, is an associative memory cell row whose stored data matches the supplied data. The priority encoder 60 is connected to the controller 22, and outputs to the controller 22 the address MATCH-ADDRESS of an associative memory cell row whose match line becomes high level when the "search" operation is effected. However, when a plurality of match lines become high level, the priority encoder 60 outputs as the address MATCH-ADDRESS the address of the associative memory cell row having a high priority in accordance with a predetermined standard, e.g., the lowest address.

Further, the match lines MATCH0 through MATCHM are respectively connected to the input terminal of an OR circuit 62. The output terminal of the OR circuit 62 is connected to the controller 22. A signal expressing whether at least one of the match lines MATCH0 through MATCHM is high level, i.e., a signal ENTIRE-MATCH which expresses whether the search data matches data stored in the associative memory cell array 26, is outputted.

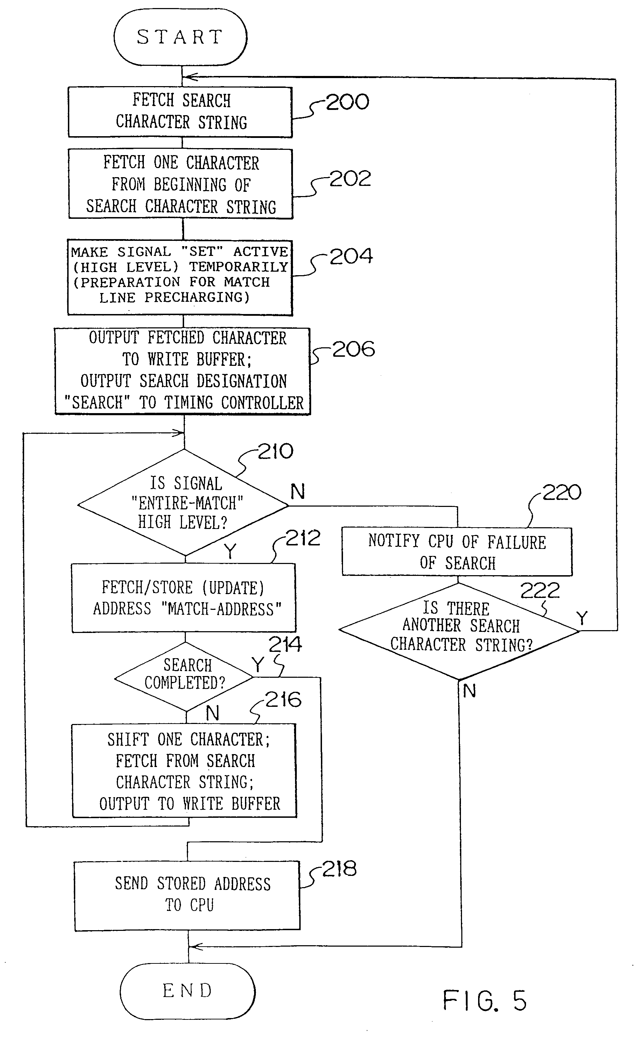

As the operation of the first embodiment, search processing of a character string will be described with reference to the flowchart in Fig. 5 as an example of search processing in the "search" mode. The flowchart in Fig. 5 is executed at the controller 22 when execution of search processing is designated from the CPU 12. Further, at this time, character string data has already been stored in the respective associative memory cells 28 of the associative memory array 26 as data to be searched. In step 200, character string data expressing a search character string stored in the RAM 16 or the like is fetched. In step 202, character data of one character is fetched from the beginning of the fetched search character string data. In step 204, the signal SET outputted to the precharge controller 58 becomes active (high level) temporarily.

When the signal SET inputted to the respective NOR circuits 70 of the precharge controllers 58₀ through 58_{M} becomes high level temporarily, the signals outputted from the NOR circuits 70 become low level. Because the MOSFET 72 is a P channel type, it is on while the clock SR is low level. The signals outputted from the NOR circuits 70 are inputted into the NOT circuits 74 and are held in the loops of the NOT circuits 74, 76.

In subsequent step 206, the character data fetched from the search character string data is outputted to the write buffer 56, and, synchronously with the signal SET becoming high level temporarily, the search designation SEARCH is outputted to the timing controller 50. Accordingly, the clock WT-SR is outputted from the timing controller 50 to the write buffer 56, and the clock SR is outputted to the precharge controllers 58₀ through 58_{M}. Precharging of the match lines MATCH in the precharge controllers 58 is thereby effected.

When the clock SR is inputted to the precharge controllers 58, the MOSFET 72 is off and the MOSFET 78 is on while the clock SR is high level. Accordingly, as described above, a high level signal is outputted from the NOT circuit 74 and is inputted to one of the input terminals of the NAND circuit 80. Because a high level signal is also inputted to the other input terminal of the NAND circuit 80, the signal outputted from the NAND circuit 80 is low level, and the MOSFET 82 is turned on, and the match lines MATCH are connected to an unillustrated power source. At this time, the match line MATCH is high level because the MOSFET 88 is on.

When the clock SR becomes low level, one of the input terminals of the NAND circuit 80 becomes low level. Therefore, the signal outputted from the NAND circuit 80 becomes high level, and the MOSFET 82 is turned off. Further, because the MOSFET 78 is turned off and the MOSFET 84 is turned on, a high level signal is supplied from the unillustrated power source to the NOT circuit 86, and the off state of the MOSFET 88 is maintained. Accordingly, the match line MATCH is in a high level state, and is electrically disconnected from the precharge controller 58. By the above-described operations being effected at the precharge controllers 58₀ through 58_{M} respectively, the match lines MATCH0 through MATCHM are charged to high levels (precharged).

When the clock WT-SR is inputted at the write buffer 56, the bit line pairs BL0,BL0' through BLN,BLN' are driven in accordance with the inputted character data. In the respective associative memory cells 28 of the associative memory cell array 26, if the data Q outputted from the NOT circuit 30 is "1" (high level), the MOSFET 38 is turned on, and if the data Q' outputted from the NOT circuit 32 is "1", the MOSFET 40 is turned on. Accordingly, if the data Q (Q') held in the loop of the NOT circuits 30, 32 and the data D (D') supplied via the bit line pair BL,BL' match, the MOSFET 42 is not turned on. However, if the data Q (Q') and the data D (D') do not match, electric current flows from the drain to the source of the one of the MOSFETs 38, 40 which is on, so that the MOSFET 42 is turned on. The levels of the precharged match lines MATCH are thereby lowered to low levels (discharging).

The above-described data comparison is effected simultaneously at all of the associative memory cells 28 while the clock SR is low level. Accordingly, precharging and data comparison are effected during one cycle of the clock SR. Because a plurality of the associative memory cells 28 (an associative memory cell row) is connected to a single match line MATCH, the comparison operation for comparing the character data stored in the associative memory cell row and the inputted character data is completed during one cycle of the clock SR. A match line is maintained in a high level state only when the MOSFETs 42 of all of the associative memory cells 28 connected to the match line are not on, i.e., only when the character data stored in the associative memory cell row and the character data inputted to the write buffer 56 match. When these data do not match, the match line becomes a low level.

Accordingly, in a case in which the character data inputted to the write buffer 56 is stored in at least one of the associative memory cell rows, the signal ENTIRE-MATCH outputted via the OR circuit 62 becomes high level, and the address of the associative memory cell row, which stores the character data inputted to the write buffer 56, is outputted from the priority encoder 60 as the address MATCH-ADDRESS. Further, while the comparison operation is being effected in the associative memory cell rows, the clock SR becomes a low level and the MOSFETs 72 in the precharge controllers 58 are turned on. Therefore, the levels of the respective match lines MATCH, which are varied in accordance with the comparison results of the respective associative memory cell rows, are transferred to and held in the NOT circuits 74, 76 of the precharge controllers 58 of the subsequent stages (e.g., the level of the match line MATCH0 is transferred to the precharge controller 58₁).

Due to the above processes, when the clock SR becomes high level, the MOSFET 78 is turned on. Similarly to the above-described precharging, if the signal outputted from the NOT circuit 74 is high level, the MOSFET 82 is turned on and the match line MATCH is charged to a high level. Further, if the signal outputted from the NOT circuit 74 is low level, the signal outputted from the NOT circuit 86 becomes high level. Therefore, the MOSFET 88 is turned on, and the match line MATCH becomes low level. In this way, if the match line of the previous stage is high level, the match line of the subsequent stage becomes high level. If the match line of the previous stage is low level, the match line of the subsequent stage becomes low level. Due to the input signal CONTROL-IN inputted from the controller 22 to the precharge controller 58₀, the match line MATCH0 always becomes low level after one comparison operation has been effected.

In subsequent step 210, a determination is made as to whether the signal ENTIRE-MATCH outputted from the OR circuit 62 is high level. When the answer to the determination in step 210 is "Yes", the process proceeds to step 212 where the address MATCH-ADDRESS which is outputted from the priority encoder 60 is fetched and stored. In step 214, a determination is made as to whether searching has been completed, i.e., as to whether character data of all of the characters forming the search character string have been outputted to the write buffer 56. If the answer to the determination in step 214 is "No", in step 216, the character data fetched from the search character string data is shifted one character and is fetched and is outputted to the write buffer 56. In this way, in the associative memory cell row connected to the match line which has become a high level as described above, comparison is effected with respect to the character data outputted to the write buffer 56.

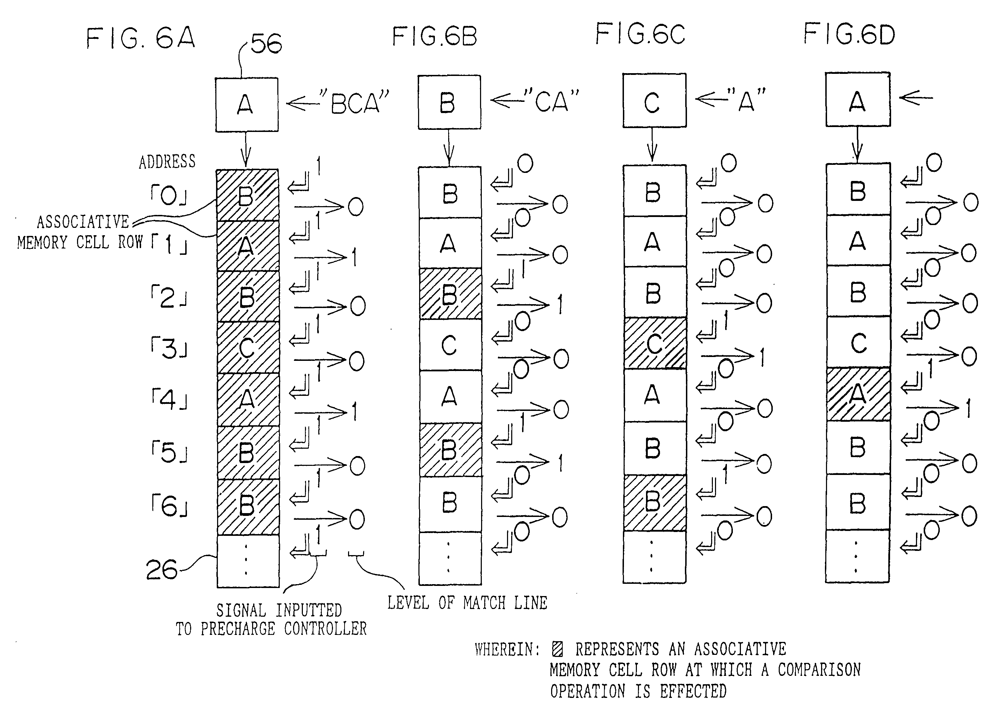

When the character data is outputted to the write buffer 56, the process returns to step 210. Thereafter, while the signal ENTIRE-MATCH is high level, the processes of steps 210 through 216 are repeated until the answer to the determination in step 214 is "Yes". Each time step 212 is executed, the stored address (MATCH-ADDRESS) is updated. The operations during this time are further illustrated with reference to Fig. 6 and based on a concrete example. In Fig. 6, the associative memory cell row is schematically represented by a block. Explanation will be given of a case in which the search character string "ABCA" is searched for from the character string to be searched "BABCABB..." which is stored in order in the associative memory cell rows of the associative memory cell array 26.

Fig. 6A illustrates a state when comparison is effected with the first character "A" of the search character string. Character data representing the character "A" is inputted to the write buffer 56. Further, due to the signal SET, which is inputted to the precharge controllers 58, temporarily becoming high level, all of the match lines become high level, and comparison operations are effected in all of the associative memory cell rows. As a result of the comparison operations, the match lines which are maintained at a high level are only the match lines corresponding to the associative memory cell rows whose addresses are "1" and "4". These results are inputted to the precharge controllers 58 of the subsequent stages (see Fig. 6B). When comparison is effected with the next character "B", only the match lines corresponding to the associative memory cell rows whose addresses are "2" and "5" have high levels, and comparison operations are effected only at the associative memory cell rows whose addresses are "2" and "5".

Because the character "B" is stored in both of the associative memory cell rows whose addresses are "2" and "5", the corresponding match lines are maintained at high levels even after the comparison operations are effected. These results are inputted to the precharge controllers 58 of the subsequent stages (see Fig. 6C). Accordingly, when comparison with the next character "C" is effected, only the match lines corresponding to the associative memory cell rows whose addresses are "3" and "6" have high levels. Here, because the character stored in the associative memory cell row whose address is "6" is not "C", only the match line corresponding to the associative memory cell row whose address is "3" is maintained at a high level, and this result is inputted to the precharge controller 58 of the subsequent stage (see Fig. 6D).

Accordingly, when the character data of the last character "D" of the search character string is inputted to the write buffer 56, a comparison operation is effected only in the associative memory cell row whose address is "4". A comparison operation is effected in the associative memory cell row whose address is "4", and if the corresponding match line is maintained at a high level, searching is completed (the answer to the determination in step 214 of the flowchart in Fig. 5 is "Yes"). As can be understood from the above description, if, for example, the search character string was "ABCAB", in addition to the above-described operations, the character data for the character "B" would be inputted to the write buffer 56, and a comparison operation would be effected.

Accordingly, even if the length of the search character string varies, only the number of times the comparison operation is repeated varies, and there is no need to change the circuit structure to match the maximum length of the search character string as in the conventional art. Further, the comparison operations for searching are effected in parallel at the respective associative memory cell rows. Regardless of the length of the character string to be searched, search processing is completed if the comparison operations are effected the same number of times as the number of characters in the search character string. Therefore, especially in cases in which the character string to be searched is very large, search processing can be completed in an extremely short time as compared with the conventional art.

Moreover, in the conventional art, the number of circuits invalidating the comparison results varies in accordance with the length of the search character string. Therefore, it is necessary to use associative memory cells or the like to which are added circuits which effect DC processing in which the comparison results from specific circuits are invalidated in accordance with the length of the search character string or the comparison results of the specific circuits are compulsorily set as "matching". However, in the present embodiment, there is no need to effect special processing even if the length of the search character string varies. Therefore, there is no need to use associative memory cells or the like to which circuits effecting DC processing are added, and the device can be made more compact.

The match lines for the associative memory cell rows for which the comparison results of the associative memory cell rows of the previous stages were "not matching" become low level and comparison operations are not effected. Therefore, as the comparison operations are repeated, the number of associative memory cell rows for which comparison operations are not effected increases, and the amount of electric power which is consumed can be decreased. In a CMOS (complimentary MOS) in particular, transient current flows when the logic state varies, and a large amount of electric power is consumed. Therefore, the amount of electric power consumed is greatly reduced by the above-described structure.

When the answer to the determination in step 214 of the flowchart in Fig. 5 is "Yes", in step 218, the stored address MATCH-ADDRESS is sent to the CPU 12 and processing is completed. Further, when the signal ENTIRE-MATCH becomes low level while the processes of steps 210 through 216 are being repeated, it can be determined that the search character string is not stored in the associative memory cell array 26. As a result, in step 220, the CPU 12 is notified that the search failed, and in step 222, a determination is made as to whether there is another search character string.

If the answer to the determination in step 222 is "Yes", the process returns to step 200, and the above-described processes are repeated. Further, if the answer to the determination in step 222 is "No", search processing ends.

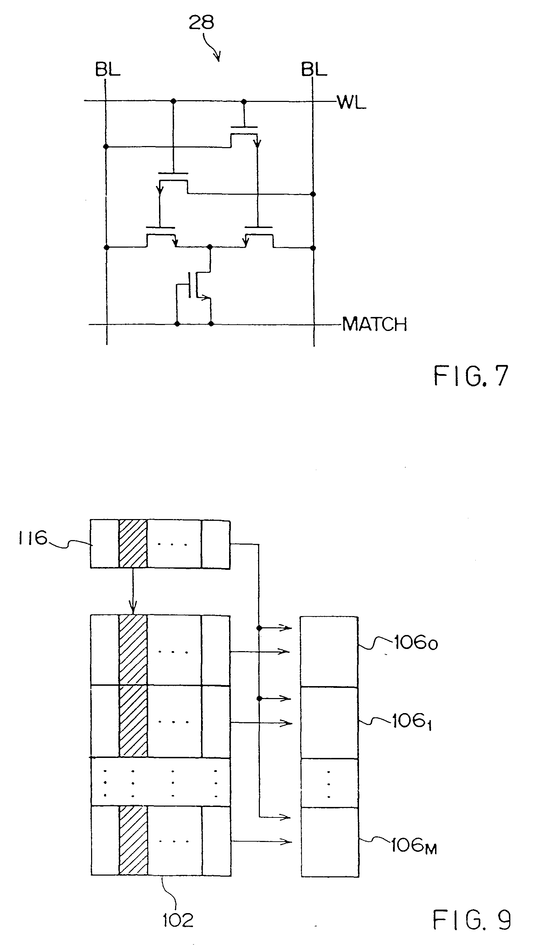

The search processing illustrated by the flowchart in Fig. 5 is a mere example, and it is possible, for example, to request the addresses of a group of associative memory cell rows in which the longest character string matching the search character string is stored. Further, the associative memory cells 28 are not limited to the SRAM type structure illustrated in Fig. 3, and a DRAM type structure such as that illustrated in Fig. 7 can be used.

A plurality of character string search devices 20 may be provided, and comparison operations with the same character data may be effected simultaneously in the respective associative memory cell arrays 26. In this case, the same data is inputted to each of the plurality of character string search devices 20 as search data, and CONTROL-OUT (see Fig. 2) of the precharge controller 58_{M} of the character string search device 20 of the previous stage and the terminal 66 (CONTROL-IN) of the precharge controller 58₀ of the character string search device 20 of the subsequent stage are connected together. Accordingly, the precharge controllers 58₀ through 58_{M} of the respective character string search devices 20 may be connected together. Besides, all matching signals ENTIRE-MATCH are combined by OR circuit.

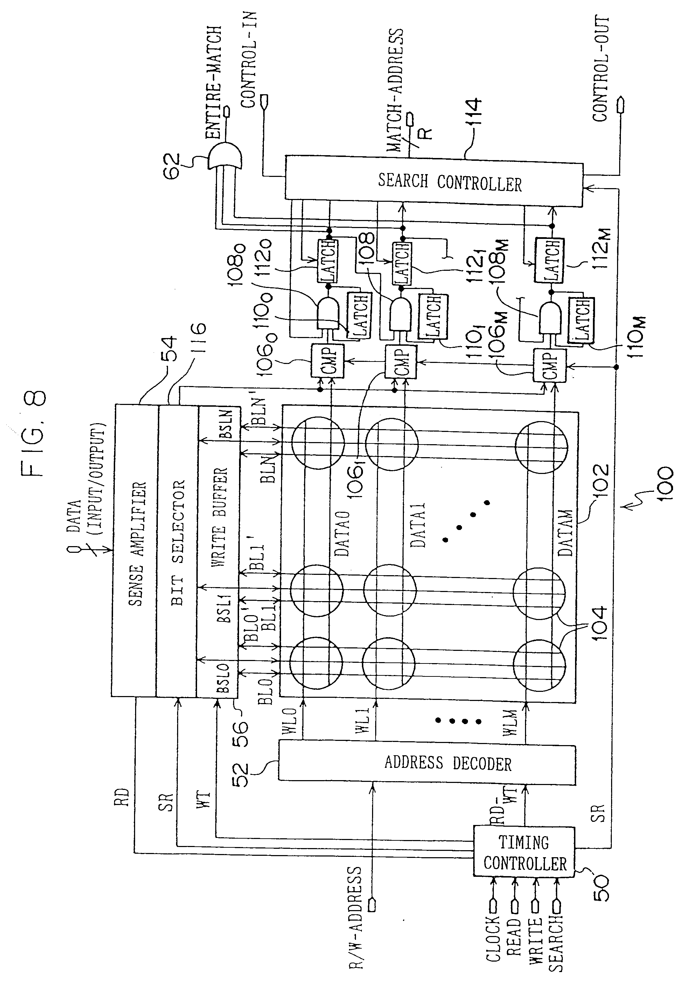

Next, a second embodiment will be described. Parts which are the same as those of the first embodiment are denoted by the same reference numerals, and description thereof is omitted. A character string search device 100 relating to the second embodiment is illustrated in Fig. 8.

In the character string search device 100, instead of the associative memory cell array of the first embodiment, a RAM cell array 102 in which RAM cells (unit cells) 104 are disposed in matrix form is provided. In the RAM cell array 102, (M+1) data lines DATA0 through DATAM are provided in place of the match lines, and (N+1) bit select lines BSL0 through BSLN are provided. The bit select lines BSL0 through BSLN are respectively connected to a bit selector 116. The bit selector 116 is connected to the timing controller 50, and during "search", the clock SR is inputted thereto. Further, the bit selector 116 is connected to the controller 22 and holds data inputted from the controller 22 during "search". In the second embodiment, the clock WT is inputted to the write buffer 56 only during "write".

When the clock SR is inputted, the bit selector 116 makes the bit select lines BSL0 through BSLN high level one at a time in order, simultaneously with the inputting of the clock SR. The data lines DATA0 through DATAM are connected to respective ones of the two input terminals of comparators 106₀through 106_{M}. When any one of the bit select lines BSL0 through BSLN is made high level by the bit selector 116, the data, which is stored in the RAM cell 104 connected to the bit select line BSL which is made high level, is outputted to the comparators 106₀ through 106_{M} via the data lines DATA0 through DATAM.

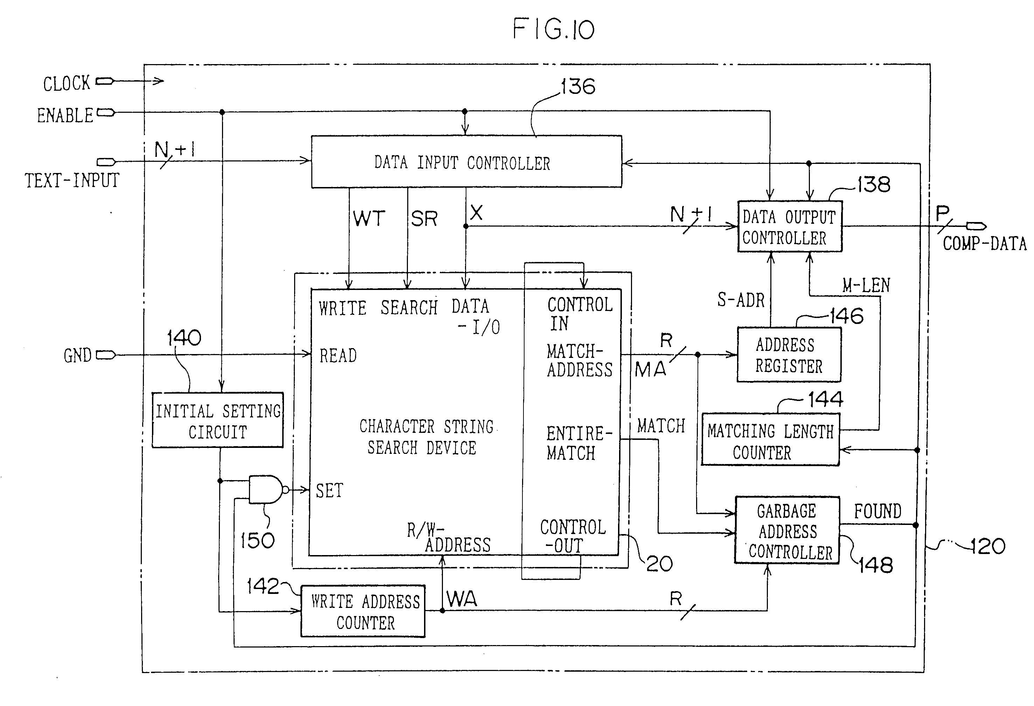

The respective other input terminals of the comparators 106₀ through 106_{M} are connected to the bit selector 116. During "search", the bit selector 116 makes the bit select lines BSL0 through BSLN high level one at a time in order as described above, and successively outputs to the comparators 106₀ through 106_{M} data of the corresponding bit among the character data which is inputted from the controller 22 and held. For example, as illustrated in Fig. 9, when the bit select line BSL1 is made high level, among the held character data, data of the second bit is outputted. In this way, among the character data which are stored or held respectively in the RAM cell rows and the bit selector 116, one-bit data of the same bit position is outputted in order to the comparators 106₀ through 106_{M} from the respective RAM cell rows and the bit selector 116.

The comparators 106₀ through 106_{M} are respectively connected to the timing controller 50, and during "search", the clock SR is inputted thereto from the timing controller 50. In this way, data of 1 bit which is inputted from the bit selector 116 and data of one bit which is inputted via the data lines DATA0 through DATAM are compared. When these data match, the output signal becomes high level, and when these data do not match, the output signal becomes low level. As described above, character data is successively inputted per 1 bit to the comparators 106 from the bit selector 116 and from the data lines DATA0 through DATAM. Therefore, the comparison results of each bit are successively outputted from the comparators 106.

The output terminals of the comparators 106₀ through 106_{M} are connected to respective ones of the three input terminals of AND circuits 108₀ through 108_{M} The output terminals of the AND circuits 108₀ through 108_{M} are connected to the input terminals of latches 110₀ through 110_{M}, respectively. The output terminals of the latches 110₀ through 110_{M} are connected to input terminals of the AND circuits 108₀ through 108_{M}. The latches 110₀ through 110_{M} are connected (unillustrated) to a search controller 114 which will be described later. When a reset signal from the search controller 114 is inputted, the latches 110₀ through 110_{M} are reset to states of maintaining high levels.

Accordingly, the levels maintained by the latches 110 and the levels of the signals outputted from the AND circuits 108 are both maintained at high levels when the comparison results of each bit successively outputted from the comparators 106 are always high level after the latches 110₀ through 110_{M} have been reset. If the comparison results become low level even once, the levels maintained by the latches 110 and the levels of the signals outputted from the AND circuits 108 become low level. However, when a low level signal is inputted to the remaining input terminals of the AND circuits 108, even if the comparison results of each bit are always high level, the signals outputted from the AND circuits 108 and the levels maintained by the latches 110 become low level.

The output terminals of the AND circuits 108₀ through 108_{M} are connected to the input terminals of latches 112₀ through 112_{M}. The output terminals and the control terminals of the latches 112₀ through 112_{M} are connected to the search controller 114. When a reset signal is inputted to the latches 112₀ through 112_{M} in the same way as to the latches 110₀ through 110_{M}, the latches 112₀ through 112_{M} are reset to states of maintaining high levels. Further, the latches 112₀ through 112_{M} fetch data only when a fetch designation is inputted thereto from the search controller 114. The output terminals of the latches 112₀ through 112_{M} are successively connected to the input terminals of the AND circuits 108 connected to the data lines of the respective subsequent stages.

The search controller 114 is connected to the timing controller 50, and during "search", the clock SR is inputted thereto from the timing controller 50. The search controller 114 counts the number of pulses of the inputted clock SR and determines whether the comparison operation with the character data held in the bit selector 116 has been completed. When the comparison operation has been completed, the fetch designation is outputted to the respective latches 112₀ through 112_{M}. As described above, because data comparison is effected per 1 bit, if, for example, the data is 8 bits, it is determined that the comparison operation has been completed at the point in time when 8 pulses are counted, and then, the fetch designation is outputted. In this way, at the point in time when the comparison with the character data held in the bit selector 116 is completed, the levels of the output signals of the AND circuits 108 are maintained in the latches 112.

The levels maintained in the latches 112 have the same meaning as the levels of the match lines when comparison operations have been completed in the first embodiment. The levels maintained in the latches 112 become high level only when the character data stored in the RAM cell rows matches the character data held in the bit selector 116. When the levels maintained in the latches 112 are low level, the signals outputted from the AND circuits 108 in the next cycle of comparison operations always become low level.

In this way, the use of the associative memory cell array 26 can be avoided if desired; the storing means may be formed by respective RAM cell rows of a RAM cell array, and the comparing means may be formed by comparators.

A plurality of the character string search devices 100 relating to the second embodiment may be provided, and comparison operations for the same character data can be effected simultaneously in each of the character string search devices 100. In this case, the CONTROL-OUT (see Fig. 8) of the search controller 114 of the character string search device 100 of the previous stage and the CONTROL-IN (see Fig. 8) of the search controller 114 of the character string search device 100 of the subsequent stage may be connected together, and the same data may be inputted to each of the plurality of character string search devices 100 as search data. Besides, all matching signals ENTIRE-MATCH are combined by OR circuit.

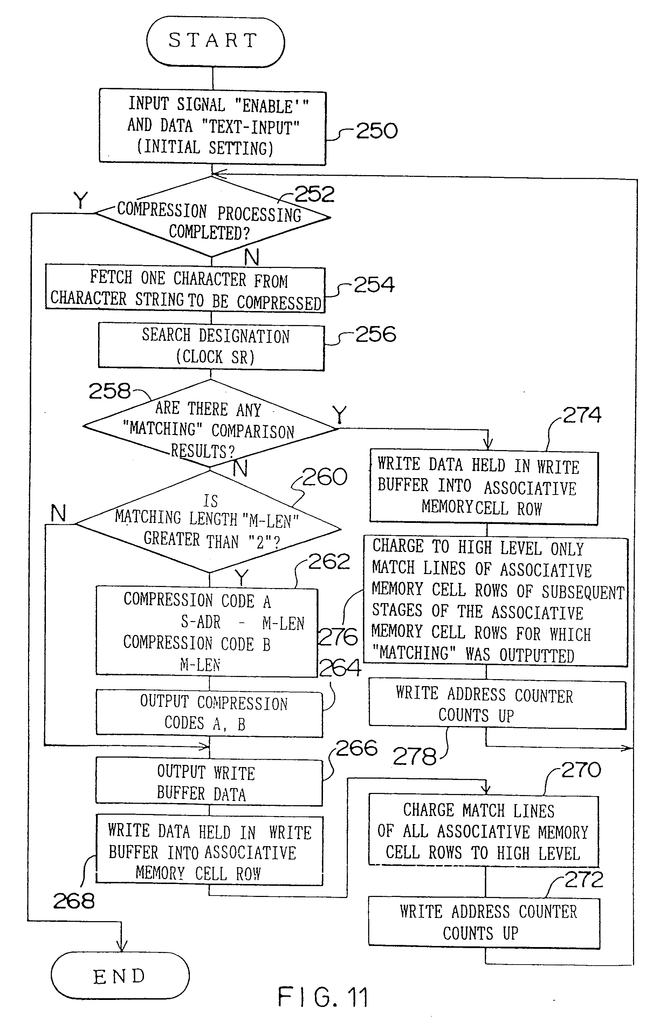

Next, a third embodiment will be described. Parts which are the same as those of the first embodiment are denoted by the same reference numerals, and description thereof is omitted. In the third embodiment, instead of the controller 22 of the first embodiment, a character string compression controller 120 illustrated in Fig. 10 is provided.

The system clock CLOCK, a signal ENABLE' which becomes low level when compression processing is effected, and character string data to be compressed (original data) TEXT-INPUT are inputted to the character string compression controller 120. The signal ENABLE' inputted to the character string compression controller 120 is supplied to a data input controller 136, a data output controller 138, and an initial setting circuit 140, respectively, so as to operate these circuits during compression processing. Further, the character string data to be compressed TEXT-INPUT which is inputted to the character string compression controller 120 is supplied to the data input controller 136.

The data input controller 136 is connected to a character string search device 122 and to the data output controller 138. In the data input controller 136, one character of character data is fetched from the beginning of the supplied character string data to be compressed, and is outputted to the write buffer 56 and the data output controller 138. Further, in the data input controller 136, the process of outputting a search designation SEARCH and a write designation WRITE, in order, to the character string search device 20 is repeated while the position of fetching the character data is shifted one character at a time to the end of the character string data. In this way, in the character string search device 20, due to the search designation SEARCH, the character data stored in the respective associative memory cell rows is compared to the character data outputted to and held in the write buffer 56. Subsequently, due to the write designation WRITE, the held character data is written into the associative memory cell array 26.

A write address counter 142 is connected to the initial setting circuit 140, and is connected to the character string search device 20 via an NAND circuit 150. When the signal ENABLE' becomes low level, the initial setting circuit 140 makes the output signal active (low level) temporarily. Accordingly, the signal SET outputted from the NAND circuit 150 becomes high level temporarily. The write address counter 142 is connected to the character string search device 20 and to a garbage address controller 148.

The write address counter 142 holds the address of a specific associative memory cell row of the associative memory cell array 26 as a count value. This count value is outputted to the character string search device 20 and to the garbage address controller 148 as an address R/W ADDRESS. When the signal inputted from the initial setting circuit 140 becomes low level, the write address counter 142 resets the held address to "0" (the address of the associative memory cell row at the beginning of the associative memory cell array 26), and the count value (address) is counted up (i.e., increased by 1) each time data is written to the associative memory cell array 26.

Accordingly, when the character data held in the write buffer 56 in accordance with the above-mentioned write designation WRITE is written into the associative memory cell array 26, along with the counting up of the address R/W-ADDRESS, the associative memory cell row in which the character data is written is successively shifted up. In the state in which the write address counter 142 holds the address of the associative memory cell row which is connected to the word line WLM (the associative memory cell row at the end of the associative memory cell array), even when writing of data to the associative memory cell array 26 is effected, the write address counter 142 resets the count value to "0".

The garbage address controller 148 is connected to the character string search device 20, and the signal ENTIRE-MATCH and the address MATCH-ADDRESS are inputted thereto from the character string search device 20. (When the comparison results of a plurality of associative memory cell rows in the character string search device 20 are "matching", the lowest address is outputted as the address MATCH-ADDRESS, as explained in the first embodiment.) When, as the result of the comparison operations in the character string search device 20, the signal ENTIRE-MATCH is maintained at a high level and the write address counter 142 has not gone once through all of the addresses, the garbage address controller 148 compares the address R/W-ADDRESS inputted from the write address counter 142 and the address MATCH-ADDRESS. When the address MATCH-ADDRESS is equal or greater, an output signal FOUND, which expresses whether the results of this comparison operation are invalid, is made active (low level, which represents invalid). The garbage address controller 148 makes the signal FOUND low level also when character string compression processing begins.

A matching length counter 144 and the data output controller 138 are connected to the garbage address controller 148 so that the signal FOUND is inputted to the matching length counter 144 and to the data output controller 138, respectively. Further, the garbage address controller 148 outputs the signal FOUND as the signal SET to the character string search device 20 via the NAND circuit 150.

After comparison operations have been effected at the character string search device 20, when the signal FOUND inputted from the garbage address controller 148 is high level, the matching length counter 144 counts up the count value (matching length). When the signal FOUND is low level, i.e., when character string compression processing begins and when the results of this comparison operation are invalid, the count value is reset to "0". The data output controller 138 is connected to the matching length counter 144, and the matching length counter 144 outputs the count value to the data output controller 138 as matching length M-LEN.

Further, an address register 146 is connected to the character string search device 20. The address MATCH-ADDRESS is inputted to the address register 146 from the character string search device 20. The address register 146 holds the address MATCH-ADDRESS and outputs it to the data output controller 138 as address S-ADR.

The data output controller 138 holds the matching length M-LEN outputted from the matching length counter 144 and the address S-ADR outputted from the address register 146. When the inputted signal FOUND continues at a high level state even after a comparison operation has been effected in the character string search device 20, the signal FOUND changes to low level after the subsequent comparison operation and comparison operations thereafter, or the data input controller 136 stops the outputting of the inputted character data until the character data fetched from the character string data to be compressed reaches the end of character string data to be compressed.

After the subsequent comparison operation and comparison operations thereafter, in cases in which the signal FOUND changes to a low level or in cases in which the character data fetched from the character string data to be compressed has reached the end of the character string data to be compressed, the data inputted from the data input controller 136 during the above-described stopping of output is, based on the held address S-ADR and the data M-REN, replaced by other data (compressed), and is outputted as compressed character string data COMP-DATA. When the signal FOUND after the previous comparison operation has been effected is low level and the signal FOUND after this comparison operation is effected is also low level, the data inputted from the data input controller 136 is outputted as is.

Next, compression processing, which is effected by the character string compression controller 120 and the character string search device 20, will be described as operation of the third embodiment with reference to the flowchart in Fig. 11.

In step 250, the signal ENABLE' and the character string data to be compressed TEXT-INPUT, which represents the character string to be compressed, are inputted as a designation to begin compression processing. Accordingly, the character string data to be compressed is held in the data input controller 136. A reset signal is outputted from the initial setting circuit 140 to the write address counter 142 and the matching length counter 148 so that the count values of the respective counters are reset to "0". Further, the signal SET inputted from the initial setting circuit 140 to the character string search device 20 via the NAND circuit 150 temporarily becomes high level and is inputted to the precharge controllers 58. As described in the first embodiment, when the signal SET becomes high level in the precharge controllers 58, the match lines become high level synchronously with the clock SR.

In step 252, a determination is made as to whether compression processing has been completed at the data input controller 136. If compression processing has not been completed, character data corresponding to one character at the beginning is fetched from the held character string data to be compressed, and is outputted to the write buffer 56 of the character string search device 20. Further, the search designation SEARCH is outputted from the data input controller 136. In this way, the clock SR and the clock WT-SR are outputted from the timing controller 50 of the character string search device 20, and comparison operations for each associative memory cell row are effected in the same way as in the first embodiment. In subsequent step 258, a determination is made at the data output controller 138 as to whether there are any associative memory cell rows whose comparison result is "matching", that is, a determination is made as to whether the signal FOUND is high level.

In the initial comparison operation, character data is not written into the respective associative memory cells 28 of the associative memory cell array 26. Therefore, the data stored in the respective associative memory cells 28 are undefined, and even if there was an associative memory cell row for which the comparison result was "matching" (i.e., the signal ENTIRE-MATCH was maintained at a high level), it would be by chance. The address R/W-ADDRESS and the address MATCH-ADDRESS, which are inputted when the signal ENTIRE-MATCH is maintained at a high level and the write address counter 142 has not gone once through all of the addresses, are compared in the garbage address controller 148. When the address MATCH-ADDRESS is equal or greater, the results of this comparison operation are invalid, and the signal FOUND becomes low level (representing "invalid"). Accordingly, at this point in time, the answer to the determination in step 258 is "No", and the process proceeds to step 260.

In step 260, in the data output controller 138, a determination is made as to whether the count value M-LEN, which represents the matching length inputted from the matching length counter 144 and which is held, is greater than "2", i.e., a determination is made as to whether the signal FOUND representing "valid" has been outputted for two comparison operations in the past. At this point in time, because the held matching length M-LEN is "0", the answer to the determination in step 260 is "No", and in step 266, the character data inputted from the data input controller 136 to the data output controller 138, i.e., the character data held in the write buffer 56, is outputted as compressed data COMP-DAT.

In subsequent step 268, the write designation WRITE is outputted from the data input controller 136. In this way, the character data held in the write buffer 56 is written into the associative memory cell array 26. The associative memory cell row into which the character data is written is the associative memory cell row corresponding to the address ("0" at this time) held in the write address counter 142.

In step 270, the low level signal FOUND is inputted to the character string search device 20 via the NAND gate circuit 150 as the high level signal SET. The respective match lines are thereby charged to high levels at the precharge controllers. In subsequent step 272, the count value is counted up at the write address counter 142, and the process returns to step 252.

In this way, while the answers to the determinations in steps 258, 260 are "No", the character data held in the write buffer 56 is outputted from the data output controller 138 as compressed character string data COMP-DATA and is stored in the associative memory cell array 26. Further, as the count value of the write address counter 142 is counted up, the address of the associative memory cell row in which the character data is written is successively shifted each time a comparison operation is effected.

When the character data held in the write buffer 56 and the character data stored in any of the associative memory cell rows match, the signal FOUND outputted from the garbage address controller 148 becomes high level (expressing "valid"), and the answer to the determination in step 258 is "Yes". In this case, as in step 266, data is not outputted and the count value is counted up by the inputting of the signal FOUND representing "valid" to the matching length counter 144. This count value is held in the data output controller 138 as the matching length M-LEN.

In step 274, the writing of the character data to the associative memory cell array 26 is effected in the same way as in step 268. In step 276, only the match lines of the associative memory rows of the subsequent stages of the associative memory rows whose match lines were maintained at high levels after a comparison operation become high level, and the match lines of the other associative memory rows become low level. In subsequent step 278, counting up of the count value is effected in the write address counter 142, and the process returns to step 252.

In this way, while the determination in step 258 is repeated and the answer thereto is "Yes", only the writing of the character data to the associative memory cell array 26 and the counting up of the matching length M-LEN are repeated. A case in which the answer for two or more repetitions of the determination in step 258 is "Yes" is a case in which the character string formed from character data inputted continuously to the write buffer 56 is stored in the associative memory cell array 26 as well, i.e., is a case in which a repeat character string, which is formed by characters of two or more characters of the character string to be compressed, has been discovered. After the processes in steps 274 through 278 have been repeated two or more times, if the determination in step 258 is "No", i.e., if there are associative memory cell rows whose comparison results were "matching" in two of the comparison operations in the past and if there are no associative memory cell rows whose comparison results are "matching" in this comparison operation, the determination in step 260 is "Yes", and the process proceeds to step 262.

In step 262, in the data output controller 138, a compression code for compressing the repeat character string discovered above is requested. A compression code is used which is formed by a compression code A, which represents a pointer indicating a position of a character string which is the same as the repeat character string which was previously outputted, and a compression code B, which represents the length of the repeat character string. The difference between the address S-ADR held in the data output controller 138 and the matching length M-LEN (S-ADR - M-LEN) is compression code A, and the matching length M-LEN is compression code B. In subsequent step 264, the compression code A and the compression code B determined as described above are outputted.

In order to distinguish between the compression code and the character data when the compressed character string is restored, each time the compression codes are output, the data output controller 138 inserts a code, which represents a separation, between the character data and the compression code. In this way, the length of the compressed character string data COMP-DATA outputted from the data output controller 138 is shorter than the character string data to be compressed TEXT-INPUT inputted to the character string compression controller 120. By repeating the above-described processes, the character string data to be compressed TEXT-INPUT is converted into the compressed character string data COMP-DATA and is outputted.

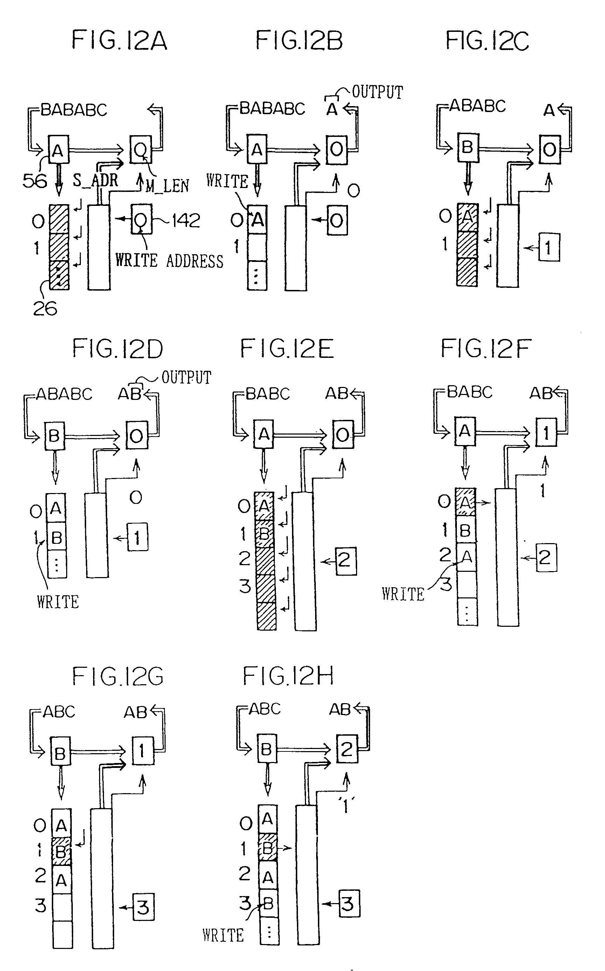

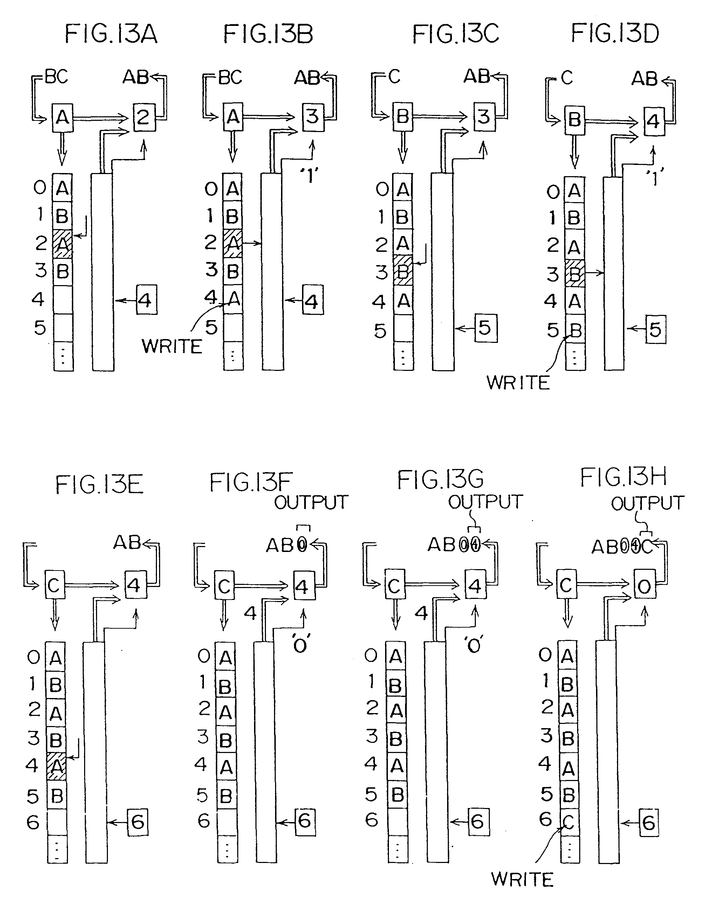

The above-described compression processes will now be described more concretely with reference to Figs. 12 and 13 and by an example of compressing the character string to be compressed "ABABABC". When character string data to be compressed TEXT-INPUT, which represents the character string to be compressed "ABABABC", is inputted to the character string compression controller 120, as illustrated in Fig. 12A, the character data corresponding to the beginning character "A" of the character string to be compressed is held in the write buffer 56 and is outputted to the data output controller 138. At this time, the count values of the write address counter 142 and the matching length counter 148 are reset to "0", and all of the match lines are charged to high levels. Accordingly, when the search designation SEARCH is outputted to the character string search device 20, comparison operations are effected in all of the associative memory cell rows. (The portions illustrated by hatching in the figures represent associative memory cell rows whose match line is a high level.)

Even if the signal ENTIRE-MATCH is maintained at a high level after the comparison operations have been effected, because the address R/W-ADDRESS held in the write address counter 142 is "0" as described above, the address MATCH-ADDRESS does not become equal to or less than the address R/W ADDRESS, and the signal FOUND outputted from the garbage address controller 148 becomes low level (i.e., "invalid", represented by "0" in the drawings) as illustrated in Fig. 12B. In this way, the character data "A" held in the write buffer 56 is outputted from the data output controller 138 as compressed character string data COMP-DATA, and is written into the associative memory cell row, whose address is "0", of the associative memory cell array 26.

Next, as illustrated in Fig. 12B, the character data of the second character "B" is held in the write buffer 56. After all of the match lines have become high level, comparison operations are effected in all of the associative memory cell rows. At this point in time, the address R/W ADDRESS held in the write address counter 142 is counted up to "1". A case in which the garbage address controller 148 outputs the signal FOUND, which represents "valid", in the comparison operation is a case in which the character data held in the write buffer 56 and the character data stored in the associative memory cell row whose address is "0" match. However, as illustrated in Fig. 12C, because these data do not match, the signal FOUND becomes low level (see Fig. 12D). In this way, the character data "B" is outputted from the data output controller 138 and is written to the address "1" of the associative memory cell array 26.

As illustrated in Fig. 12E, next, the character data of the third character "A" is held in the write buffer 56. After all of the match lines have become high level, comparison operations are effected at all of the associative memory cell rows. At this time, the character data held in the write buffer 56 and the character data stored in the associative memory cell row whose address is "0" match, and the MATCH-ADDRESS becomes "0". Therefore, as illustrated in Fig. 12F, the signal FOUND outputted from the garbage address controller 148 becomes high level (represented by "1" in the figures). Accordingly, output of character data is not effected at the data output controller 138, and the character data held in the write buffer 56 is written to the address "2" of the associative memory cell array 26. Further, the matching length M-LEN is counted up to "1".

Subsequently, as illustrated in Fig. 12G, the character data of the fourth character "B" is held in the write buffer 56. Only the match line of the address (address "1") after the address whose character data matched becomes high level, and comparison processing is effected only at the associative memory cell row whose address is "1". Because the results of this comparison operation are also "matching", as illustrated in Fig. 12H, the signal FOUND continues at a high level. Output of character data is not effected at the data output controller 138, and the character data held in the write buffer 56 is written to the address "3" of the associative memory cell array 26. Further, the matching length M-LEN, which expresses the matching length, is counted up to "2".

As illustrated in Fig. 13A, the character data of the fifth character "A" is held in the write buffer 56. Only the match line of address "2" becomes high level, and a comparison operation is effected. The results of this comparison operation are also "matching", and, as illustrated in Fig. 13B, the signal FOUND continues at a high level. Output of character data is not effected at the output controller 138, the character data held in the write buffer 56 is written to the address "4" of the associative memory cell array 26, and the matching length M-LEN is counted up to "3".

Next, as illustrated in Fig. 13C, character data of the sixth character "B" is held in the write buffer 56. Only the match line of the address "3" becomes high level, and a comparison operation is effected. The results of this comparison are also "matching". As illustrated in Fig. 13D, the signal FOUND continues at a high level. Output of character data is not effected at the data output controller 138, the character data held in the write buffer 56 is written to the address "4" of the associative memory cell array 26, and the matching length M-LEN is counted up to "4".

As illustrated in Fig. 13E, next, character data of the final character "C" is held in the frame buffer 56. Only the match line of the address "4" becomes high level, and a comparison operation is effected. The results of this comparison are "not matching", and as illustrated in Fig. 13F, the signal FOUND changes to low level. At this time, the matching length M-LEN held in the data output controller 138 is "4" (i.e., greater than or equal to "2"). Therefore, the character string which has not been outputted until now (the repeat character string) is replaced by the compression code A and the compression code B and is outputted.

Specifically, the address S-ADR held in the data output controller 138 is "4", and the matching length M-LEN which represents the matching length is "4". Therefore, in the character string which has already been outputted as the compressed character string data COMP-DATA, the beginning position of the character string which is the same as the repeat character string is S-ADR - M-LEN = 0. As illustrated in Fig. 13F, the compression code A (represented by "(0)" in the figure), which represents the beginning position "0" of the character string, is outputted. Subsequently, as illustrated in Fig. 13G, the compression code B (represented by "(4)" in the figure), which represents the length "4" of the repeat character string, is outputted.

Next, as illustrated in Fig. 13H, the character data of "C" held in the write buffer 56 is outputted from the data output controller 138 and is written to the address "6" of the associative memory cell array 26. The matching length M-LEN is reset to "0", and compression processing is thereby completed.

As is clear from the above-described operations, when, for example, the character string to be compressed is "ABABABCA", in addition to the above operations, the character "A" is inputted to the write buffer 56 and a comparison operation is effected. Even if the length of the character string to be compressed varies, only the number of times the comparison operation is repeated varies, and compression of the character string to be compressed can be effected in an extremely short and fixed processing time. Further, even if the length of the character string to be compressed is very large and the amount of data thereof is greater than the storage capacity of the associative memory cell array 26, as in the present embodiment, when the write address arrives at the final address of the associative memory cell array 26, the write address may be returned to "0", and character data may be written by using the associative memory cell array 26 as a ring buffer. There is no need to use an associative memory cell array having a large storage capacity.

Further, it is preferable from the standpoint of the data compression rate as well that the storage capacity of the associative memory cell array 26 is not overly large. Namely, if the storage capacity of the associative memory cell array 26 is large, the amount of data which can be stored at one time is large. Therefore, the probability that a "matching" comparison result is outputted in the comparison operation increases. However, if the storage capacity is too large, the number of bits for expressing the address MATCH-ADDRESS is large. Therefore, the number of bits of compression code A increases, and the compression rate decreases.

For example, if the storage capacity of the associative memory cell row is one byte, 12 bits are allocated for an address, and an appropriate storage capacity of the associative memory cell array 26 is about 2¹²= 4096 bytes. Further, because one character is represented by two bytes in Japanese text, when Japanese text is compressed, it is efficient for the storage capacity of the associative memory cell row to be 2 bytes. In this case, if the storage capacity of the associative memory cell array 26 is 4096 as described above, an address can be expressed by 11 bits.

Next, a fourth embodiment will be described. Parts which are the same as those of the third embodiment are denoted by the same reference numerals, and description thereof is omitted.

In the data input controller 138 relating to the fourth embodiment, when the level of the signal FOUND after the previous comparison operation is high level and the signal FOUND changes to low level after this comparison operation, the outputting of the character data inputted from the data input controller 136 is stopped, and a control signal prohibiting the output of the write designation WRITE to the character string search device 20 is outputted to the data input controller 136 (the signal line is omitted from the drawings). In this way, comparison of the character data stored in all of the associative memory cell rows with respect to the character data held in the write buffer 56 is effected.

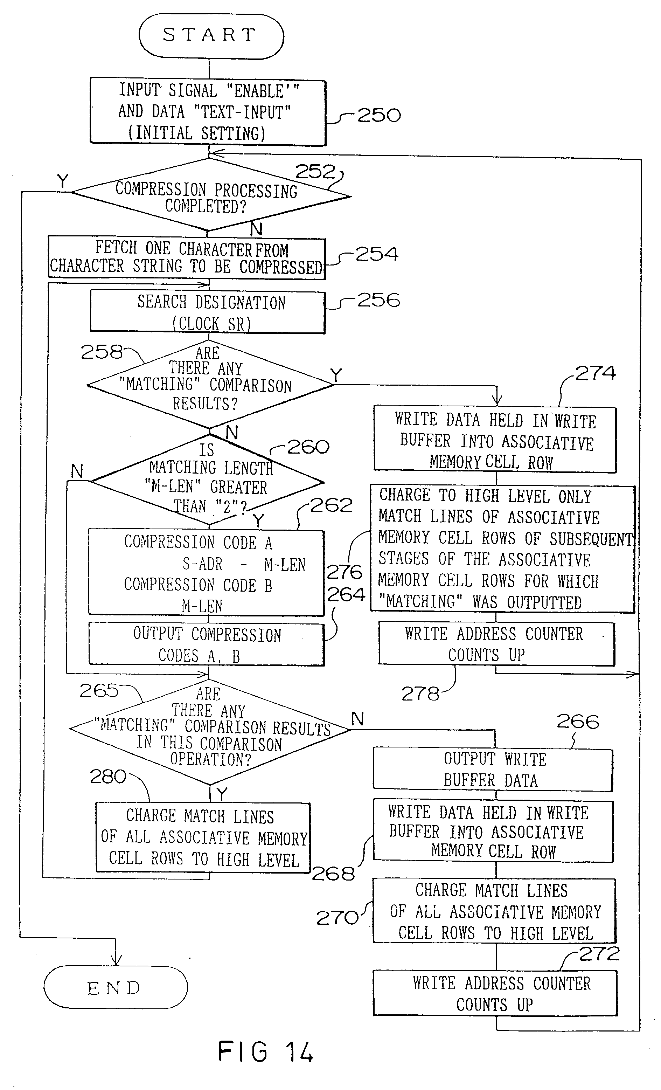

Compression processing of the fourth embodiment will now be described with reference to the flowchart in Fig. 14. When there are no associative memory cell rows whose comparison results of this comparison operation are "matching", the answer to the determination in step 258 is "No". After the answer to the determination in step 260 is "No" or after the answer to the determination in step 260 is "Yes" and the processes of step 262 and step 264 have been carried out, in step 265, a determination is effected at the data output controller 138 as to whether there are any associative memory cell rows whose comparison results of this comparison operation are "matching". Specifically, this determination can be made by determining whether the matching length M-LEN is greater than or equal to "1".

When there are no associative memory cell rows whose comparison results of this comparison operation are "matching" and the answer to the determination in step 265 is "No", in this comparison operation, comparison of the character data stored in all of the associative memory cell rows to the character data held in the write buffer 56 is being effected. Therefore, as described in the third embodiment, the processes of steps 266 through 272 are effected, and the process returns to step 252. If there are associative memory cells whose comparison results of the previous comparison operation were "matching", in this comparison operation, comparison of only the character data stored in specific associative memory cell rows to the character data held in the write buffer 56 is effected, and there is the possibility that the character data held in the write buffer 56 matches character data stored in associative memory cell rows for which comparison is not effected in this comparison operation.

As a result, the data output controller 138 stops the outputting of the character data inputted from the data input controller 136, and outputs to the data input controller 136 the control signal prohibiting the output of the write designation WRITE to the character string search device 20. Accordingly, as shown in step 280, as there are associative memory cell rows whose comparison results of this comparison operation are "matching" and the signal FOUND changes to low level, all of the match lines are charged to high level. Rewriting of the character data held in the write buffer 56 is not effected, and the process returns to step 256. The search designation SEARCH is outputted from the data input controller 136, and a comparison of the character data stored in all of the associative memory cell rows to the character data held in the write buffer 56 is effected.

Accordingly, even in a case in which there are adjacent repeat character string data, each of a length of two characters or more, in the character string data to be compressed TEXT-INPUT, all of the characters of these repeat character string data can be detected as repeat character string data, and all of the repeat character strings included in the character string data to be compressed TEXT-INPUT can be detected without there being any misses. Accordingly, the compression rate improves even in comparison to the compression processing of the third embodiment.

In order to further improve the compression ratio, the number of bits of the code (compression code A) representing the pointer which indicates the position of the character string which is the same as the repeat character string, and the number of bits of the code (compression code B) which represents the length of the repeat character string may be varied appropriately in accordance with the length of the data written in the associative memory cell array. For example, if the storage capacity of an associative memory cell row is one byte, the number of bits necessary for addressing until data of 256 bytes is written in the associate memory cell array, i.e., the number of bits necessary to indicate the position of the character string which is the same as the repeat character string, is "8", and the number of bits necessary until data of 1024 bytes is written is "10". Further, the maximum value of the length of the repeat character string also is varied in accordance with the amount of data written in the associative memory cell array.

Accordingly, when the amount of data stored in the associative memory cell array is small, the number of bits of compression code A and compression code B can be made small. Therefore, when compression processing begins, the number of bits of compression code A and compression code B is small, and is then increased in accordance with the increase in the amount of data written into the associative memory cell array. In this way, the compression ratio of the character string data to be compressed TEXT-INPUT can be improved.

If the length of the repeat character string in the above description is "two characters" or more, the repeat character string can be replaced by a compression code. However, this reference value can be made even higher. The reason why the reference value is not "1 character" is that if one character is replaced by a compression code when only one character matches in the above description, a high compression rate cannot be obtained. Therefore, it is preferable that a length of two characters or more is used as the reference value.

If the character string data to be compressed is written to the associative memory cell rows in a descending order of the addresses (i.e., written from the end), it is preferable that the priority encoder 60 outputs the highest address as the address MATCH-ADDRESS when a plurality of match lines are high level.

The restoration of the compressed character string data COMP-DATA to character string data to be compressed can be effected by the character string compression controller 120 temporarily storing in the associative memory cells 28 the character string data to be compressed which was already restored from the compressed data COMP-DATA, and by restoring the compressed character string data, which is continuous with the compressed character string data which was already restored to the character string data to be compressed, to character string data to be compressed by using the stored character string data to be compressed.

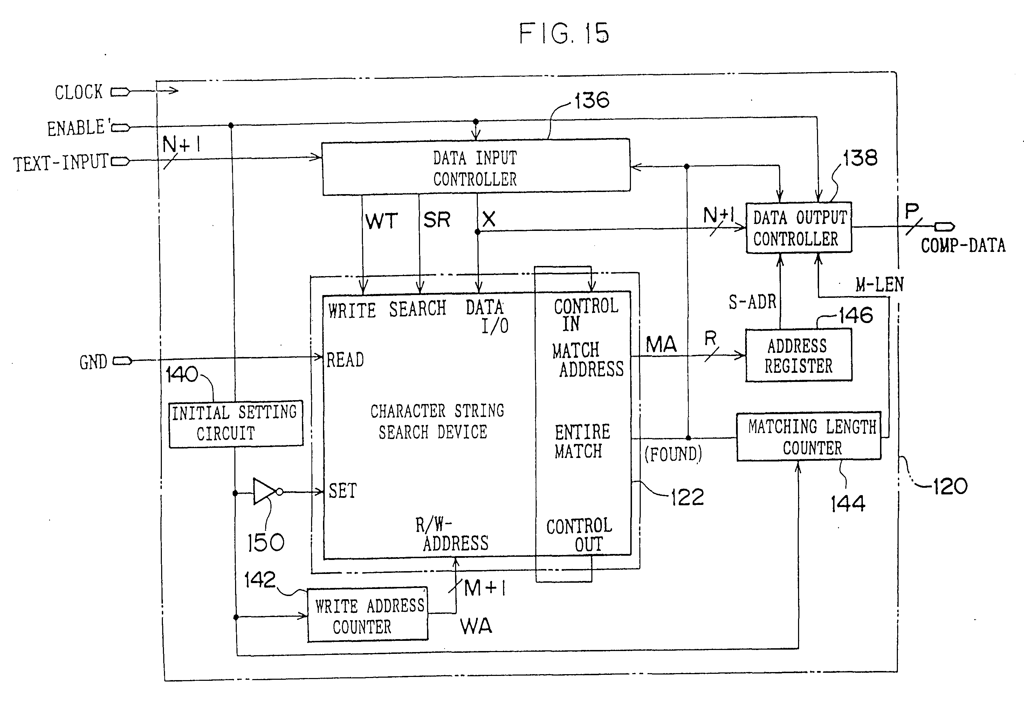

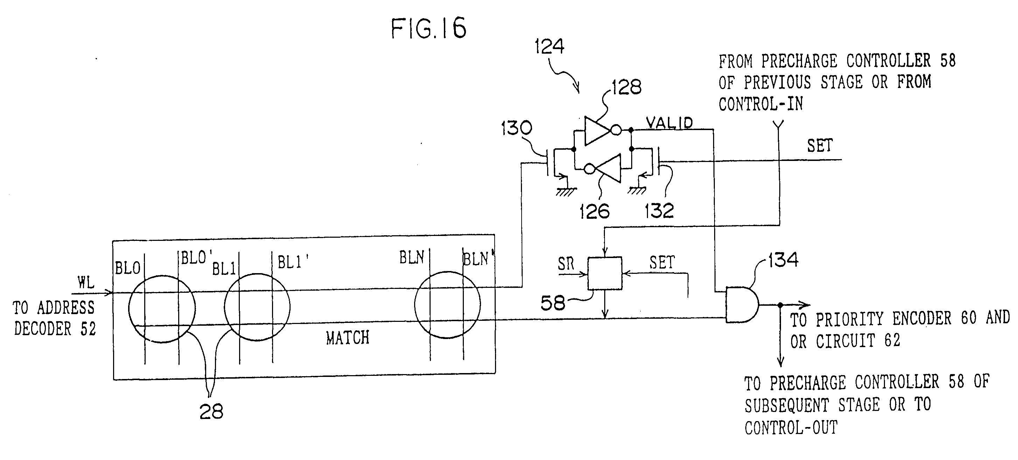

Next, a fifth embodiment will be described. Parts which are the same as those of the third embodiment are denoted by the same reference numerals, and description thereof is omitted. In the fifth embodiment, as illustrated in Fig. 15, the garbage address controller 148 is omitted, the NAND circuit 150 is replaced by the NOT circuit 151, and a garbage address control circuit 124 illustrated in Fig. 16 is connected to each of the precharge controllers 58₀ through 58_{M}. Further, the matching length counter 144 is connected to the initial setting circuit 140. When a reset signal is inputted from the initial setting circuit 140, the count value is reset to "0".

The garbage address control circuit 124 is provided with a latch which is formed by two NOT circuits 126, 128 whose input terminals and output terminals are connected together. The output terminal of the NOT circuit 126 is connected to the drain of a MOSFET 130. The gate of the MOSFET 130 is connected to a word line WL, and the source is grounded. Further, the output terminal of the NOT circuit 128 is connected to the drain of a MOSFET 132. The gate of the MOSFET 132 is connected to the controller 22, and the signal SET is inputted to the gate of the MOSFET 132. The source of the MOSFET 132 is grounded.

The output terminal of the NOT circuit 128 is connected to one of the two input terminals of an AND circuit 134 (hereinafter, the signal outputted from the NOT circuit 128 is called the signal VALID). The other input terminal of the AND circuit 134 is connected to a match line. The output terminal of the AND circuit 134 is bifurcated. One furcation is connected to the priority encoder 60 (see Fig. 2), and the other furcation is connected to the NOR circuit 70 of the precharge controller 58 (see Fig. 4).

When compression processing begins, when the signal SET is inputted to the character string search device 20, in each of the garbage address control circuits 124, the MOSFET 132 is turned on. The input side of the NOT circuit 126 becomes low level, and this state (the state in which the signal VALID is low level) is maintained by the NOT circuits 126, 128. In the state in which the signal VALID outputted from the garbage address control circuit 124 is low level, the signal outputted from the AND circuit 134 always becomes low level. Therefore, the results of the comparison operations at associative memory cell rows in which data is not written, i.e., in which stored data is undefined, do not effect the signal ENTIRE-MATCH nor the address MATCH-ADDRESS.

Further, when data is written to a specific associative memory cell row, the word line WL connected to the specific associative memory cell row becomes high level. In this way, the MOSFET 130 of the garbage address control circuit 124 is turned on, the input side of the NOT circuit 128 becomes low level, and this state (the high level state of the signal VALID) is maintained by the NOT circuits 126, 128. Accordingly, even if all of the match lines are charged to high levels, associative memory cell rows whose comparison results are outputted to the priority encoder 60 and the OR circuit 62 are only the cell rows in which data is written. Comparison operations are substantially stopped for cell rows in which data is not written.

Methods of excluding comparison results outputted from associative memory cell rows in which data is not written are not limited to the above-described methods of providing the garbage address controller 148 or providing the garbage address control circuits 124 for the respective precharge controllers 58. For example, in the initial setting, before compression and restoring of data, set data determined in advance can be stored each time in all of the associative memory cell rows of the associative memory cell array 26 so that outputting of "matching" comparison results from associative memory cell rows in which data is not written can be prevented.

Further, in the fifth embodiment, the priority encoder 60 may be structured such that when the match lines of a plurality of associative memory cell rows become high level, the priority encoder 60 outputs, as the address MATCH-ADDRESS, the address of the associative memory cell row, among the plurality of associative memory cell rows, in which character data has been written most recently. Further, the address register 146 may be structured so as to output, as the address S-ADR, the difference between the address MATCH-ADDRESS and the address R/W ADDRESS (i.e., the distance between the repeat character data and the same character data which has already appeared).

This may be realized by the following structure: the address R/W-ADDRESS, which is inputted from the character string compression controller 120 to the address decoder 52 of the character string search device 20, is connected to a signal line so as to be inputted to the priority encoder 60 and the address register 146 as well. On the basis of the address R/W-ADDRESS and the order of writing the character data (ascending order or descending order of the addresses), the priority encoder 60 determines the address of the associative memory cell row in which character data has most recently been written, among the addresses of the plurality of associative memory cell rows whose match lines have become high level. At the address register 146, the difference between the address MATCH-ADDRESS and the address R/W-ADDRESS is calculated and outputted.

If the priority encoder 60 and the address register 146 are structured as described above, when a plurality of character strings which are the same as the repeat character string are detected, the address S-ADR outputted from the address register 146 is data representing the distance between the repeat character string and the same character string having the minimum distance from the repeat character string, i.e., the minimum value of the respective distances between the repeat character string and the plurality of character strings which are the same as the repeat character string. The data output controller 138 calculates and outputs (S-ADR - M-REN) as the compression code A. If the data output controller 138 is structured such that the number of bits of the compression code A is varied in accordance with the value of the address S-ADR inputted from the address register 146, more specifically, if the data output controller 138 is structured such that if the value of the address S-ADR is small, the number of bits is decreased, and if the value of the address S-ADR is large, the number of bits is increased, the probability that data having a small number of bits will be outputted as the compression code A increases. Therefore, the compression ratio of the character string data to be compressed TEXT-INPUT can be improved.

The above description was explained by using character data as an example of data. However, processing can be effected for various types of data such as image data, voice data, document data, executable form programs and the like. Also, in the above description, compression processing is effected by an algorithm corresponding to LZ77, but may also be made applicable to various compression algorithms necessary for searching.

## Claims

1. A data search device (20) comprising:
storage apparatus (26) for storing data to be searched, the data comprising a sequence of data segments of predetermined bit length, said apparatus comprising a plurality of ordered storage units (28), each capable of storing a data segment;
a plurality of comparing means (58), each associated with a respective storage unit, for outputting a matching signal when a data segment stored in a storage unit matches an inputted data segment;
and control means (20) for fetching in turn a succession of data segments from search data comprising a plurality of data segments, and for inputting a fetched search data segment to each of said plurality of comparing means adjacent to a comparing means which outputted said matching signal for the preceding data segment.

2. A data compression device including the data search device of claim 1, wherein the control means (20) fetches in turn data segments from the data string to be compressed; inputs the fetched data segment to the comparing means, whereby: if a matching signal is produced by at least one of the comparing means, the next data segment is inputted only to the comparing means adjacent to the comparing means which outputted a matching signal; or if a matching signal is not produced by at least one of the comparing means, then dependent on the number of preceding data segments that were matching, outputting as the compressed data either the inputted data segment(s), or a predetermined code representative of the data segments; and stores the fetched data segment in the next storage unit.

3. The data compression device of claim 2, wherein if the preceding data segment outputted a matching signal, so that the current data segment was only inputted to some of the comparing means, and none of these produced a matching signal, retaining the same data segment as the next data segment, so that this time the data segment is inputted to all of the comparing means.

4. The data compression device of claim 2 or 3, wherein the storage units are logically ordered as a circular buffer.

5. The data compression device of any of claims 2 to 4, wherein said control means is provided with a counting means (144) for counting the number of successive data segments for which a matching signal is outputted from a comparing means, said predetermined code being formed by using the count of the counting means and the identity of the storage unit corresponding to comparing means which outputted the last matching signal.

6. The data compression device of claim 5, wherein said control means varies the number of bits of said predetermined code in accordance with the number of storage units currently storing data segments.

7. The data compression device of claim 5 or 6, wherein said predetermined code includes a distance code representative of the distance between the storage unit which stores the fetched data segment when the last matching signal was outputted, and the storage unit corresponding to the comparing means which outputted the last matching signal, and said control means varies the number of bits of said distance code in accordance with the magnitude of said distance.

8. The data compression device of claim 7, wherein if a plurality of matching signals were obtained for the previous data segment but none for the current data segment, the control means selects from the storage units corresponding to the comparing means which outputted matching signals the one which produces the smallest distance.

9. The data compression device of any of claims 2 to 8, further comprising invalidation control means (148) for invalidating a matching signal outputted from a comparing means if the storage unit corresponding to said comparing means is included in a region of the storage apparatus in which data segments have not yet been stored.

10. The data compression device of claim 9, further comprising holding means (142) for identifying which parts of the storage apparatus have been used for storing data segments.

11. The data compression device of any of claims 2 to 10, wherein said control means causes said plurality of storage units to temporarily store data which has already been restored from said compressed data, and by using said stored data, said control means restores compressed data following on from the compressed data which has already been restored.

12. A data compression method for compressing an input data string comprising a sequence of data segments, using storage apparatus having a plurality of ordered storage units each capable of storing one data segment, and a plurality of comparing means each associated with a storage unit, the comparing means outputting a matching signal when the data inputted thereto matches the data segment in the associated storage unit, said data compression method comprising the steps of:
(a) fetching data segments in turn from the input data string,
(b) inputting the fetched data segment to the comparing means adjacent to the comparing means which outputted a matching signal for the previous data segment, or to all the comparing means if no matching signal was produced for the previous data segment, and if a matching signal is not produced by at least one of the comparing means, then dependent on the number of preceding data segments that were matching, outputting as the compressed data either the inputted data segment(s), or a predetermined code representative of the data segments,
(c) and storing the fetched data segment in the next storage unit.

13. The data compression method of claim 12, wherein if no matching signal was outputted for the current data segment, but a matching signal was outputted by the preceding data segment, repeating step (b) before progressing to step (c).
